# EUROPEAN PATENT APPLICATION

(11) **EP 4 750 294 A1**
(43) Date of publication of application: **27.05.2026**
(21) Application number: 25198705.3
(22) Date of filing: 28.08.2025
(51) Int. Cl.: H10K 59/40, H10K 59/80, H10K 59/88, H10K 59/122

(54) **DISPLAY DEVICE**

(30) Priority: 21.11.2024 KR 20240167293
(71) Applicant: LG Display Co., Ltd., Seoul, 07336 (KR)
(72) Inventor: OH, Se-Wan, 10845 Paju-si (KR); LEE, Yong-Ku, 10845 Paju-si (KR); YOON, A-Ra, 10845 Paju-si (KR); LEE, Young-Bok, 10845 Paju-si (KR); KIM, Go-Eun, 10845 Paju-si (KR)
(74) Representative: Poll, Christopher

(57) **Abstract**

A display device may include: a display area and a non-display area outside the display area; a light emitting diode disposed in the display area and on a substrate; an insulating layer covering the light emitting diode and disposed in the display area and the non-display area; lenses disposed in the display area and on the insulating layer; a stopper disposed in the non-display area and on the insulating layer; first flatness-enhancing patterns disposed between the display area and the stopper; and a planarization layer covering the lenses, the stopper and the first flatness-enhancing patterns. The non-display area may include a first non-display area at a first direction from the display area and a second non-display area at a second direction from the display area. The first flatness-enhancing patterns may be disposed in the first non-display area and include a convex pattern or a concave pattern.

## Description

### CROSS-REFERENCE TO RELATED APPLICATIONS

The present application claims the benefit of and priority to Korean Patent Application No. 10-2024-0167293 filed in the Republic of Korea on November 21, 2024, the entire contents of which are incorporated herein by reference for all purposes .

### 1. Technical Field

The present disclosure relates to a display device, and more specifically, for example, without limitation, to a display device being capable of reducing or preventing a light leakage at an edge and providing high quality image.

### 2. Discussion of the Related Art

Recently, requirement for flat panel display devices having small occupied area is increased. Among the flat panel display devices, a technology of a liquid crystal display device, an organic light emitting display device and an inorganic light emitting display device is rapidly developed.

For example, in the organic light emitting display device, holes from an anode and electrons from a cathode are combined to generate an exciton in an organic light emitting layer, and the exciton is transformed from an excited state to a ground state. As a result, the light is emitted from the OLED.

The description provided in the discussion of the related art section should not be assumed to be prior art merely because it is mentioned in or associated with that section. The discussion of the related art section includes information that describes one or more aspects of the subject technology, and the description in this section does not limit the present disclosure.

### SUMMARY

One or more aspects of the present disclosure are directed to a display device that substantially obviates one or more of the limitations associated with the limitations and disadvantages of the related conventional art.

A benefit of the present disclosure is to provide a display device being capable of overcoming a limitation in a viewing angle and/or an optical efficiency.

A benefit of the present disclosure is to provide a display device being capable of improving a viewing angle and/or an optical efficiency without a light leakage limitation.

A benefit of the present disclosure is to provide a display device being capable of improving a flatness of a planarization layer.

Additional features and advantages of the present disclosure are set forth in the description which follows, and will be apparent from the description, or evident by practice of the present disclosure. The benefits and other advantages of the present disclosure are realized and attained by the features described herein as well as in the appended drawings.

To achieve these and other advantages in accordance with the purpose of the embodiments of the present disclosure, as described herein, an aspect of the present disclosure is a display device comprising a substrate; a display area and a non-display area outside the display area; a light emitting diode disposed in the display area and on the substrate; an insulating layer covering the light emitting diode and disposed in the display area and the non-display area; a plurality of lenses disposed in the display area and on the insulating layer; a stopper disposed in the non-display area and on the insulating layer; a plurality of a first flatness-enhancing patterns disposed between the display area and the stopper; and a planarization layer covering the plurality of lenses, the stopper and the plurality of first flatness-enhancing patterns, wherein the non-display area includes a first non-display area at a first direction from the display area and a second non-display area at a second direction from the display area, and wherein the plurality of first flatness-enhancing patterns are disposed in the first non-display area and include a convex pattern or a concave pattern.

Other systems, methods, features and advantages will be, or will become, apparent to one with skill in the art upon examination of the following figures and detailed description. It is intended that all such additional systems, methods, features and advantages be included within this description, be within the scope of the present disclosure, and be protected by the following claims. Nothing in this section should be taken as a limitation on those claims. Further aspects and advantages are discussed below in conjunction with embodiments of the disclosure.

It is to be understood that both the foregoing general description and the following detailed description are examples and explanatory and are intended to further explain the present disclosure as claimed.

### BRIEF DESCRIPTION OF THE DRAWINGS

The accompanying drawings, which are included to provide a further understanding of the present disclosure, are incorporated in and constitute a part of this present disclosure, illustrate aspects and embodiments of the present disclosure, and together with the description serve to explain principles and examples of the disclosure.
FIG. 1 is a schematic view illustrating an organic light emitting display device of the present disclosure.
FIG. 2 is a schematic circuit diagram of an organic light emitting display device of the present disclosure.
FIG. 3 is a schematic cross-sectional view illustrating an organic light emitting display device according to a first embodiment of the present disclosure.
FIG. 4 is a schematic cross-sectional view illustrating an organic light emitting display device according to a second embodiment of the present disclosure.
FIG. 5 is a schematic cross-sectional view illustrating one pixel region in the organic light emitting display device according to the second embodiment of the present disclosure.
FIG. 6 is a schematic plan view illustrating a portion of an organic light emitting display device according to the second embodiment of the present disclosure.
FIG. 7 is a schematic plan view illustrating a portion of an organic light emitting display device according to the second embodiment of the present disclosure.
FIG. 8 is a schematic plan view illustrating a portion of an organic light emitting display device according to the second embodiment of the present disclosure.
FIG. 9 is a schematic plan view illustrating a portion of an organic light emitting display device according to the second embodiment of the present disclosure.
FIG. 10 is a schematic cross-sectional view illustrating an organic light emitting display device according to a third embodiment of the present disclosure.

Throughout the drawings and the detailed description, unless otherwise described, the same drawing reference numerals should be understood to refer to the same elements, features, and structures. The sizes, lengths, and thicknesses of layers, regions and elements, and depiction thereof may be exaggerated for clarity, illustration, and/or convenience.

### DETAILED DESCRIPTION

Reference will now be made in detail to aspects of the present disclosure, examples of which may be illustrated in the accompanying drawings. In the following description, when a detailed description of well-known functions or configurations related to this document is determined to unnecessarily cloud a gist of the inventive concept, the detailed description thereof will be omitted or may be briefly provided. The progression of processing steps and/or operations described is an example; however, the sequence of steps and/or operations is not limited to that set forth herein and may be changed as is known in the art, with the exception of steps and/or operations necessarily occurring in a particular order. Like reference numerals designate like elements throughout. Names of the respective elements used in the following explanations are selected only for convenience of writing the specification and may be thus different from those used in actual products.

Advantages and features of the present disclosure and methods of achieving them will be apparent with reference to the aspects described below in detail with the accompanying drawings. However, the present disclosure is not limited to the aspects disclosed below, but can be realized in a variety of different forms, and only these aspects allow the disclosure of the present disclosure to be complete. The present disclosure is provided to fully inform the scope of the disclosure to the skilled in the art of the present disclosure.

The shapes, sizes, proportions, angles, numbers, and the like disclosed in the drawings for explaining the aspects of the present disclosure are illustrative, and the present disclosure is not limited to the illustrated matters. The same reference numerals refer to the same elements throughout the specification. In addition, in describing the present disclosure, if it is determined that a detailed description of the related known technology unnecessarily obscure the subject matter of the present disclosure, the detailed description thereof can be omitted or may be briefly provided. When "including," "having," "consisting," and the like are used in this specification, other parts may be added unless "only" is used. When a component is expressed in the singular, cases including the plural are included unless specific statement is described. For example, an element may be one or more elements. An element may include a plurality of elements. The word "exemplary" is used to mean serving as an example or illustration. Embodiments are example embodiments. Aspects are example aspects. In one or more implementations, "embodiments," "examples," "aspects," and the like should not be construed to be preferred or advantageous over other implementations. An embodiment, an example, an example embodiment, an aspect, or the like may refer to one or more embodiments, one or more examples, one or more example embodiments, one or more aspects, or the like, unless stated otherwise.

Any implementation described herein as an "example" is not necessarily to be construed as preferred or advantageous over other implementations.

In addition, when any dimensions, relative sizes etc. are mentioned, it should be considered that numerical values for an elements or features, or corresponding information (e.g., level, range, etc.) include a tolerance or error range that may be caused by various factors (e.g., process factors, internal or external impact, noise, etc.) even when a relevant description is not specified. Further, the term "may" fully encompasses all the meanings of the term "can."

Also, when an element or layer is "connected," "coupled," or "adhered" to another element or layer, this denotes that the element or layer can not only be directly connected or adhered to another element or layer, but also be indirectly connected or adhered to another element or layer with one or more intervening elements or layers "disposed," or "interposed" between the elements or layers, unless otherwise specified. It should be understood to mean that elements may be so disposed to directly contact each other, or may be so disposed without directly contacting each other.

The expression "at least one of a, b, and c" described throughout the specification can encompass "a alone," "b alone," "c alone," "a and b," "a and c," "b and c," or "all of a, b, and c." The advantages and features of the present disclosure, and the methods for achieving them, will become apparent by referring to the embodiments described in detail below together with the accompanying drawings.

In construing an element, the element is construed as including an error or tolerance range although there is no explicit description of such an error or tolerance range.

In describing a position relationship, for example, when a position relation between two parts is described as, for example, "on," "over," "under," and "next," one or more other parts may be disposed between the two parts unless a more limiting term, such as "just" or "direct(ly)" is used.

In describing a time relationship, for example, when the temporal order is described as, for example, "after," "subsequent," "next," and "before," a case that is not continuous may be included unless a more limiting term, such as "just," "immediate(ly)," or "direct(ly)" is used.

The area, length, or thickness of each component described in the specification is illustrated for convenience of explanation, and the present disclosure is not necessarily limited to the area and thickness of the illustrated component.

It will be understood that, although the terms "first," "second," etc. may be used herein to describe various elements, these elements should not be limited by these terms. These terms are only used to distinguish one element from another. For example, a first element could be termed a second element, and, similarly, a second element could be termed a first element, without departing from the scope of the present disclosure.

Features of various aspects of the present disclosure may be partially or overall coupled to or combined with each other, and may be variously inter-operated with each other and driven technically as those skilled in the art can sufficiently understand. The aspects of the present disclosure may be carried out independently from each other, or may be carried out together in co-dependent relationship.

Unless otherwise defined, all terms (including technical and scientific terms) used herein have the same meaning as commonly understood by one of ordinary skill in the art to which example embodiments belong. It will be further understood that terms, such as those defined in commonly used dictionaries, should be interpreted as having a meaning for example consistent with their meaning in the context of the relevant art and should not be interpreted in an idealized or overly formal sense unless expressly so defined herein. For example, the term "part" or "unit" may apply, for example, to a separate circuit or structure, an integrated circuit, a computational block of a circuit device, or any structure configured to perform a described function as should be understood to one of ordinary skill in the art.

Rather, these embodiments may be provided so that this disclosure may be sufficiently thorough and complete to assist those skilled in the art to fully understand the scope of the present disclosure. Furthermore, the present disclosure is only defined by scopes of claims.

Without specific description, a transistor constituting the pixel circuit of the present disclosure may include at least one of an oxide thin film transistor (Oxide TFT), an amorphous silicon TFT (a-Si TFT), and a low temperature poly silicon (LTPS) TFT.

The following embodiments are described with reference to organic light emitting display devices. However, the embodiment of the present disclosure is not limited to organic light emitting display devices. For example, a display device according to an embodiment of the present disclosure may be an organic light emitting display device using an organic light emitting material, an inorganic light emitting display device using an inorganic light emitting material such as a quantum dot or a micro-LED display device using a micro-LED.

It will be apparent to those skilled in the art that various modifications and variations can be made in the display device of the present disclosure without departing from the technical idea or scope of the disclosures. Thus, it is intended that the present disclosure covers the modifications and variations of this disclosure provided they come within the scope of the appended claims and their equivalents.

Reference will now be made in detail to some of the examples and preferred embodiments, which are illustrated in the accompanying drawings.

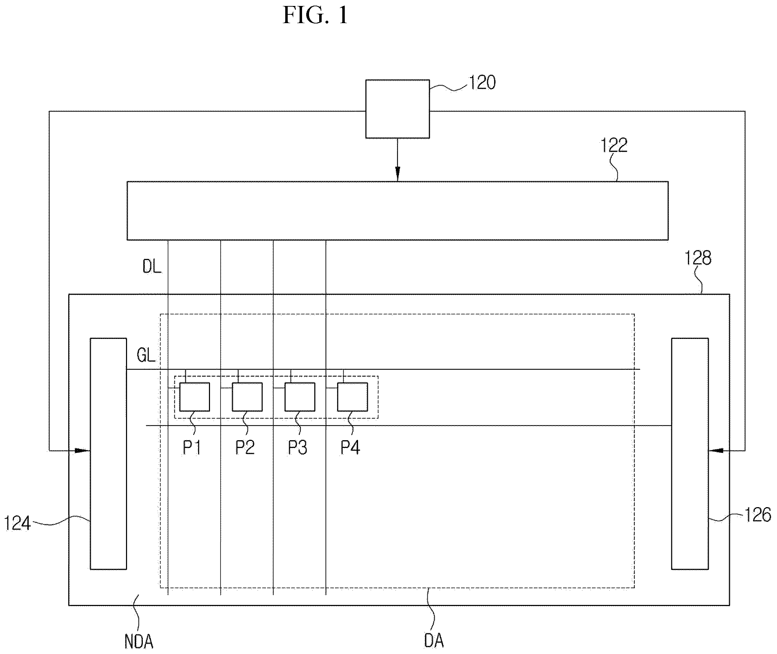

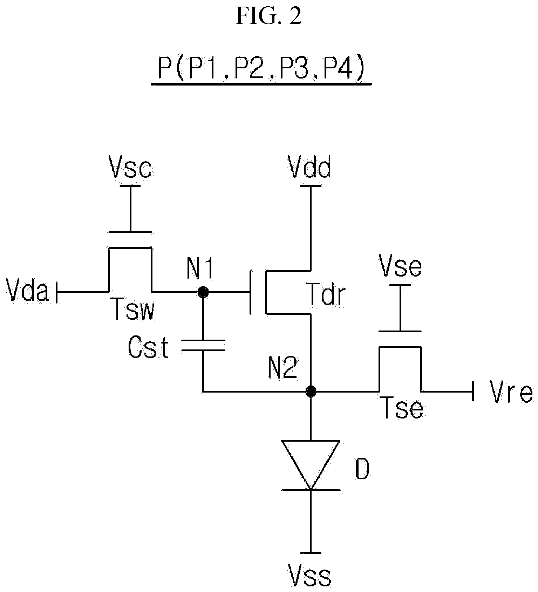

FIG. 1 is a schematic view illustrating an organic light emitting display device of the present disclosure, and FIG. 2 is a schematic circuit diagram of an organic light emitting display device of the present disclosure.

As shown in FIGs. 1 and 2, a display device 110 according to an embodiment of the present disclosure includes a timing controlling unit 120 (e.g., a circuit), a data driving unit 122 (e.g., a circuit), first and second gate driving units 124 and 126 (e.g., circuits) and a display panel 128.

The timing controlling unit 120 generates an image data RGB, a data control signal and a gate control signal using an image signal and a plurality of timing signals including a data enable signal, a horizontal synchronization signal, a vertical synchronization signal and a clock signal transmitted from an external system. The timing controlling unit 120 transmits the image data and the data control signal to the data driving unit 122, and transmits the gate control signal to the first and second gate driving units 124 and 126.

The data driving unit 122 generates a data signal (a data voltage) Vda using the image data and the data control signal transmitted from the timing controlling unit 120 and transmits the data signal Vda to a data line DL of the display panel 128.

The first and second gate driving units 124 and 126 generate a gate signal (a gate voltage) Vsc and Vse using the gate control signal transmitted from the timing controlling unit 120 and applies the gate signal Vsc and Vse to a gate line GL of the display panel 128.

The first and second gate driving units 124 and 126 may have a gate in panel (GIP) type to be formed in a non-display area NDA of a substrate of the display panel 128 having the gate line GL, the data line DL and a pixel.

Although the first and second gate driving units 124 and 126 are disposed in both side portions of the display panel 128 in the embodiment of FIG. 1, one gate driving unit may be disposed in one side portion of the display panel 128 in another embodiment.

The display panel 128 includes a display area DA at a central portion thereof and a non-display area NDA surrounding the display area DA. The display panel 128 displays an image using the gate signal Vsc and Vse and the data signal Vda.

In the display panel 128, the gate line GL and the data line DL cross each other to define first to fourth pixel regions P1, P2, P3 and P4. For example, the first to fourth pixel region P1 to P4 may be red, green, blue and white pixel regions, respectively.

In each of the first to fourth pixel regions P1 to P4, a switching TFT Tsw, a driving TFT Tdr, a sensing TFT Tse, a storage capacitor (Cst) and a light emitting diode D may be disposed.

The switching transistor Tsw, the driving transistor Tdr and the sensing transistor Tse may have a negative type. Alternatively, at least one of the switching transistor Tsw, the driving transistor Tdr and the sensing transistor Tse may have a positive type in another embodiment.

The switching transistor Tsw is switched according to a scan signal Vsc to transmit a data signal Vda to a first node N1.

The driving transistor Tdr is switched according to a voltage of the first node N1 to transmit a high level signal (high level voltage) Vdd to a second node N2.

The sensing transistor Tse is switched according to a sensing signal (sensing voltage) Vse to transmit a reference signal (reference voltage) Vre to the second node N2 or transmit a voltage of the second node N2 to a reference line.

The storage capacitor Cst keeps the data signal Vda supplied to the first node N1 for one frame and stores a threshold voltage Vth of the driving transistor Tdr.

A first capacitor electrode of the storage capacitor Cst is connected to the first node N1, and a second capacitor electrode of the storage capacitor Cst is connected to the second node N2.

The light emitting diode D emits a light of a luminance proportional to a current of the driving transistor Tdr.

An anode of the light emitting diode D is connected to the second node N2, and a cathode of the light emitting diode D is connected to a low level power line to receive a low level signal (low level voltage) Vss.

The light emitting diode D may display an image having a luminance corresponding to the image data RGB according to a driving of subpixel circuits of the first to fourth pixel regions P1 to P4.

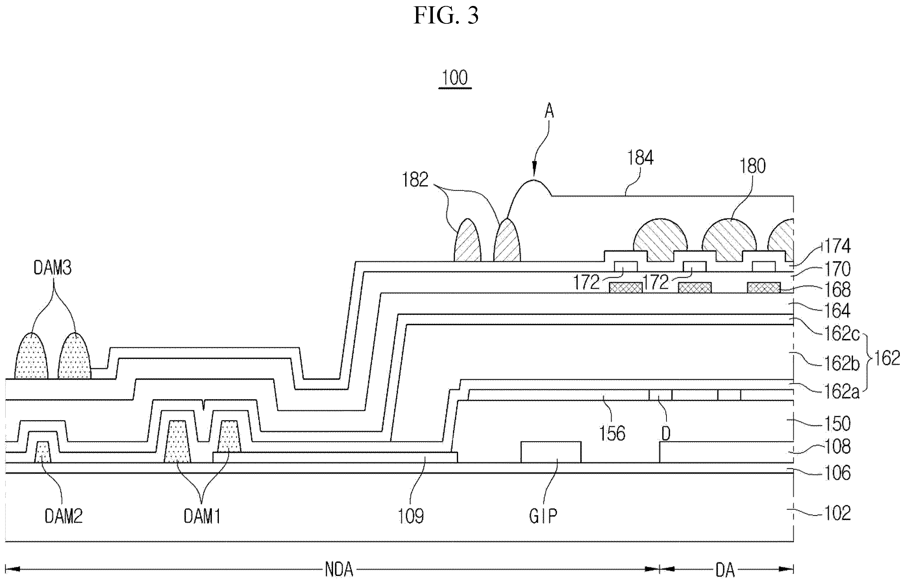

As shown in FIG. 3, an organic light emitting display device 100 includes a substrate 102 including a display area DA and a non-display area NDA, a light emitting diode D disposed over the substrate 102 and in the display area DA, an organic interlayer insulating layer 170 disposed over the light emitting diode D, a plurality of lenses 180 disposed on the organic interlayer insulating layer 170 and in the display area DA, a stopper 182 disposed on the organic interlayer insulating layer 170 and in the non-display area NDA and a second planarization layer 184 covering the plurality of lenses 180.

A plurality of pixel regions are defined in the display area DA and on the substrate 102. The substrate 102 may be a glass substrate or a plastic substrate.

A first buffer layer 106 is disposed on the substrate 102. The first buffer layer 106 may serve as blocking external moisture and/or oxygen. A pixel circuit layer 108, a gate driving part GIP and a signal line 109 are disposed on the first buffer layer 106. The pixel circuit layer 108 corresponds to the display area DA, and the gate driving part GIP and the signal line 109 correspond to the non-display area NDA. The gate driving part GIP may be positioned between the display area DA and the signal line 109.

For example, the pixel circuit layer 108 may include a switching thin film transistor (TFT), a driving TFT and a sensing TFT. The signal line 109 may include a low potential signal line providing a low potential signal (VSS).

A first planarization layer 150 is disposed on the first buffer layer 106 to cover the pixel circuit layer 108 and the gate driving part GIP. The first planarization layer 150 may cover a part of the signal line 109.

The light emitting diode D and a bank 156 are disposed on the first planarization layer 150. The light emitting diode D corresponds to each pixel region in the display area DA, and the bank 156 corresponds to a boundary of the pixel region. The bank 156 may extend into a portion of the non-display area NDA. The bank 156 may include a light-absorbing particle, e.g., a black particle, to have a light-absorbing property.

A first dam DAM1 and a second dam DAM2 are disposed in the non-display area NDA. Each of the first and second dams DAM1 and DAM2 has a rectangular ring shape surrounding the display area DA.

The first dam DAM1 is positioned between the display area DA and the second dam DAM2. Each of the second dam DAM2 and a portion of the first dam DAM1 may be positioned on the first buffer layer 106, and the other portion of the first dam DAM1 may be positioned on the signal line 109.

An encapsulation layer 162 reducing or preventing penetration of moisture and/or oxygen is disposed on the light emitting diode D and the bank 156. The encapsulation layer 162 in the non-display area NDA may cover the first and second dams DAM1 and DAM2.

The encapsulation layer 162 may have a multi-layered structure including a first inorganic insulating layer 162a, an organic insulating layer 162b and a second inorganic insulating layer 162c sequentially stacked.

The organic insulating layer 162b may be formed in an area surrounding the first dam DAM1. Each of the first and second inorganic insulating layers 162a and 162c may cover the first and second dams DAM1 and DAM2 and be formed on an entire substrate 102. Accordingly, a side of the organic insulating layer 162b may be covered with the second inorganic insulating layer 162c.

A second buffer layer 164 is disposed on the encapsulating layer 162. The second buffer layer 164 may serve as blocking external moisture and/or oxygen.

A black matrix 168 corresponding to a space between adjacent light emitting diodes D is disposed on the second buffer layer 164. For example, the black matrix 168 may correspond to a boundary of the pixel region. The bank 156 may have a first opening corresponding to the pixel region, and the black matrix 168 may have a second opening, which is larger than the first opening, corresponding to the pixel region.

Although not shown, a color filter layer corresponding to the pixel region may be disposed on the second buffer layer 164.

The organic interlayer insulating layer 170 is disposed on an entire substrate 102 to cover the black matrix 168. The organic interlayer insulating layer 170 may be formed of an organic insulating material, e.g., photo-acryl or benzocyclobutene (BCB).

A touch electrode 172 corresponding to the display area DA is disposed on the organic interlayer insulating layer 170. The touch electrode 172 is positioned to correspond to the black matrix 168. An inorganic insulating layer 174 is disposed on the touch electrode 172. The inorganic insulating layer 174 may have an area being smaller than the substrate 102 to expose a portion of the organic interlayer insulating layer 170 at an edge of the substrate 102.

The plurality of lenses 180 and the stopper 182 are disposed on the inorganic insulating layer 174. In addition, a third dam DAM3 is disposed on the organic interlayer insulating layer 170 exposed by the inorganic insulating layer 174. The lenses 180 are positioned in the display area DA, and each of the stopper 182 and the third dam DAM3 are positioned in the non-display area NDA. The stopper 182 is positioned between the third dam DAM3 and the lenses 180.

The lenses 180, the stopper 182 and the third dam DAM3 may be formed of the same or substantially same material.

The second planarization layer 184 is disposed over the substrate 102 to cover and planarize the lenses 180. The second planarization layer 184 may be formed of an organic insulating material, e.g., aryl resin, epoxy resin, phenolic resin, polyamide resin or polyimide resin. The organic insulating material of the lens 180 has a first refractive index, and the organic insulating material of the second planarization layer 184 has a second refractive index being smaller than the first refractive index.

In the display device 100 of the present disclosure, the lenses 180 are provided over the light emitting diode D so that a viewing angle can be restricted and/or a light efficiency can be improved.

In addition, the lenses 180 can be planarized by the second planarization layer 184.

However, as shown in FIG. 3, the second planarization layer 184 may not be formed beyond the stopper 182 to the third dam DAM3, and the second planarization layer 184 may protrude in an area A close to the stopper 182. Accordingly, a flatness cannot be secured. For example, a solution for forming the second planarization layer 184 may be dropped on the display area DA and spread toward the non-display area NDA to form the second planarization layer 184 having a flat surface, but the spreading speed of the solution between the display area DA and the stopper 182 is slow. As a result, the solution does not go beyond the stopper 182 and accumulates in the front portion A of the stopper 182 so that the second planarization layer 184 protrudes.

The protruding portion of the second planarization layer 184 acts like a lens so that the light leakage limitation may be caused in the non-display area.

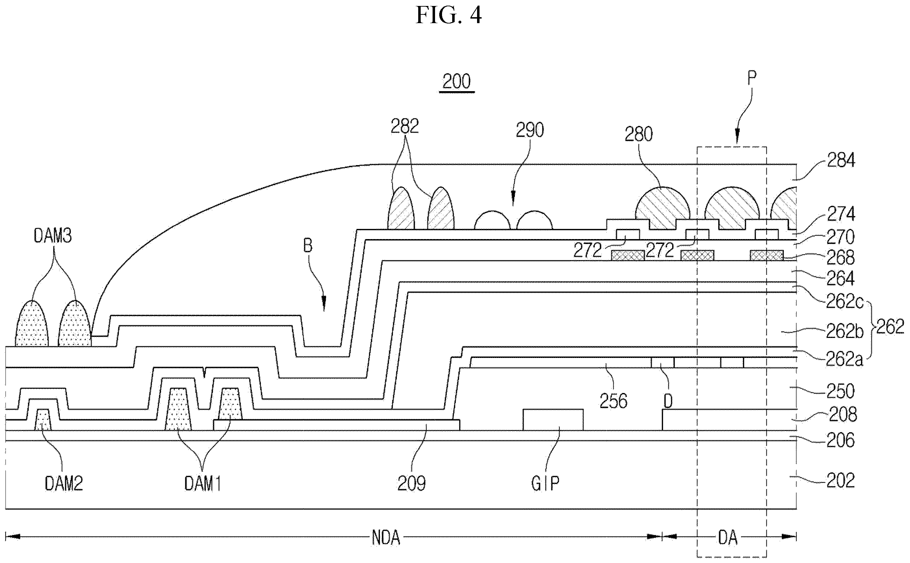

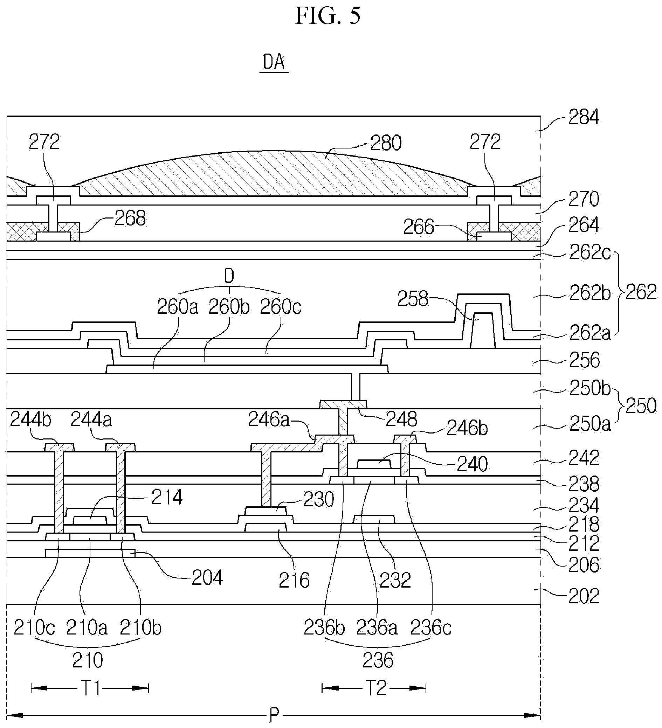

FIG. 4 is a schematic cross-sectional view illustrating an organic light emitting display device according to a second embodiment of the present disclosure, and FIG. 5 is a schematic cross-sectional view illustrating one pixel region in the organic light emitting display device according to the second embodiment of the present disclosure. Referring to FIGs. 4 and 5, an organic light emitting display device 200 includes a substrate 202 including a display area DA and a non-display area NDA, a light emitting diode D disposed over the substrate 202 and in the display area DA, an organic interlayer insulating layer 270 disposed over the light emitting diode D, a plurality of lenses 280 disposed on the organic interlayer insulating layer 270 and in the display area DA, a stopper 282 disposed on the organic interlayer insulating layer 270 and in the non-display area NDA, a flatness enhancing pattern 290 disposed on the interlayer insulating layer 270 and in the non-display area NDA and a second planarization layer 284 covering the plurality of lenses 280, the flatness enhancing pattern 290 and the stopper 282.

A plurality of pixel regions P are defined in the display area DA and on the substrate 202. The substrate 202 may be a glass substrate or a plastic substrate. For example, the substrate 202 may be one of polyimide (PI) substrate, polyethersulfone (PES) substrate, polyethylenenaphthalate (PEN) substrate, polyethylene terephthalate (PET) substrate and polycarbonate (PC) substrate.

In an aspect of the present disclosure, the substrate may have a triple-layered structure including a first polyimide layer, a second polyimide layer and an interlayer inorganic layer between the first and second polyimide layers. The interlayer inorganic layer may be formed of an inorganic insulating material, e.g., silicon oxide or silicon nitride.

A first buffer layer 206 is disposed on the substrate 202. A pixel circuit layer 208, a gate driving part GIP and a signal line 209 are disposed on the first buffer layer 206. The pixel circuit layer 208 corresponds to the display area DA, and the gate driving part GIP and the signal line 209 correspond to the non-display area NDA. The gate driving part GIP may be positioned between the display area DA and the signal line 209.

Referring to FIG. 5, a specific laminated structure of an organic light emitting display device 200 including a pixel circuit layer 208 in a display area is described.

A first light shielding pattern 204 is disposed on the substrate 202. The light through the substrate 202 can be blocked by the first light shielding pattern 204. For example, the first light shielding pattern 204 may be formed of a metallic material, e.g., molybdenum (Mo), aluminum (Al), chromium (Cr), gold (Au), titanium (Ti), nickel (Ni), neodymium (Nd), copper (Cu) or their alloy, and have a single-layered structure or a multi-layered structure.

A first buffer layer 206 covering the first light shielding pattern 204 is disposed over the substrate 202. The moisture and/or oxygen can be blocked by the first buffer layer 206. For example, the first buffer layer 206 may be formed of an inorganic insulating material, e.g., silicon oxide or silicon nitride, and have a single-layered structure or a multi-layered structure. When the first light shielding pattern 204 is omitted, the first buffer layer 206 may be directly formed on the substrate 202 and contact the substrate 202.

A first semiconductor layer 210 corresponding to the first light shielding pattern 204 is disposed on the first buffer layer 206. The first semiconductor layer 210 may include one of a poly-semiconductor material, an amorphous semiconductor material and an oxide semiconductor material. When the first light shielding pattern 204 and the first buffer layer 206 are omitted, the first semiconductor layer 210 may be directly disposed on the substrate 202.

In an aspect of the present disclosure, the first semiconductor layer 210 may be formed of a poly-semiconductor material, e.g., polycrystalline silicon. The first semiconductor layer 210 may include a first channel region 210a, a first source region 210b at one side of the first channel region 210a and a first drain region 210c at the other side of the first channel region 210a. Impurities may be dopped into the first source and drain regions 210b and 210c.

A gate driving part GIP and a signal line 209 are disposed on the first buffer layer 206 and in the non-display area NDA. The gate driving part GIP may be positioned between the display area DA and the signal line 209. The signal line 209 may include a low potential signal line for providing a low potential signal (Vss).

A first gate insulating layer 212 covering the first semiconductor layer 210 is disposed over the first buffer layer 206. The first gate insulating layer 212 may be formed of an inorganic insulating material, e.g., silicon oxide or silicon nitride, and have a single-layered structure or a multi-layered structure.

A first gate electrode 214 corresponding to the first channel region 210a of the first semiconductor layer 210 is disposed on the first gate insulating layer 212. In addition, a first capacitor electrode 216, which is spaced apart from the first gate electrode 214, is disposed on the first gate insulating layer 212.

The first gate electrode 214 and the first capacitor electrode 216 may be disposed on the same or substantially same layer and be formed of the same or substantially same material. For example, each of the first gate electrode 214 and the first capacitor electrode 216 may be formed of a metallic material, e.g., Mo, Al, Cr, Au, Ti, Ni, Nd, Cu or their alloy, and have a single-layered structure or a multi-layered structure.

A first interlayer insulating layer 218 covering the first gate electrode 214 and the first capacitor electrode 216 is disposed on the first gate insulating layer 212. The first interlayer insulating layer 218 may be formed of an inorganic insulating material, e.g., silicon oxide or silicon nitride, and have a single-layered structure or a multi-layered structure.

A second capacitor electrode 230 corresponding to the first capacitor electrode 216 and a second light shielding pattern 232 spaced apart from the second capacitor electrode 230 are disposed on the first interlayer insulating layer 218.

The second capacitor electrode 230 and the second light shielding pattern 232 may be disposed on the same or substantially same layer and be formed of the same or substantially same material. For example, each of the second capacitor electrode 230 and the second light shielding pattern 232 may be formed of a metallic material, e.g., Mo, Al, Cr, Au, Ti, Ni, Nd, Cu or their alloy, and have a single-layered structure or a multi-layered structure.

A second interlayer insulating layer 234 covering the second capacitor electrode 230 and the second light shielding pattern 232 is disposed on the first interlayer insulating layer 218. The external moisture and/or oxygen can be blocked by the second interlayer insulating layer 234. For example, the second interlayer insulating layer 234 may be formed of an inorganic insulating material, e.g., silicon oxide or silicon nitride, or an organic insulating material, e.g., photo-acryl or benzocyclobutene (BCB), and have a single-layered structure or a multi-layered structure.

A second semiconductor layer 236 corresponding to the second light shielding pattern 232 is disposed on the second interlayer insulating layer 234. The second semiconductor layer 236 may include one of a poly-semiconductor material, an amorphous semiconductor material and an oxide semiconductor material.

In an aspect of the present disclosure, the second semiconductor layer 236 may be formed of an oxide semiconductor material, e.g., indium-gallium-zinc oxide (IGZO), zinc oxide (ZnO), tin oxide (SnO2), copper oxide (Cu2O), nickel oxide (NiO), indium-tin-zinc oxide (ITZO) or indium-aluminum-zinc oxide (IAZO).

The second semiconductor layer 236 may include a second channel region 236a, a second source region 236b at one side of the second channel region 236a and a second drain region 236c at the other side of the second channel region 236a. Impurities may be dopped into the second source and drain regions 236b and 236c.

A second gate insulating layer 238 covering the second semiconductor layer 236 is disposed over the second interlayer insulating layer 234. The second gate insulating layer 238 may be formed of an inorganic insulating material, e.g., silicon oxide or silicon nitride, and have a single-layered structure or a multi-layered structure.

A second gate electrode 240 corresponding to the second channel region 236a of the second semiconductor layer 236 is disposed on the second semiconductor layer 236. For example, the second gate electrode 240 may be formed of a metallic material, e.g., Mo, Al, Cr, Au, Ti, Ni, Nd, Cu or their alloy, and have a single-layered structure or a multi-layered structure.

A third interlayer insulating layer 242 covering the second gate electrode 240 is disposed on the second gate insulating layer 238. The third interlayer insulating layer 242 may be formed of an inorganic insulating material, e.g., silicon oxide or silicon nitride, and have a single-layered structure or a multi-layered structure.

A first source electrode 244a, a first drain electrode 244b, a second source electrode 246a and a second drain electrode 246b are disposed on the third interlayer insulating layer 242.

The first source electrode 244a and the first drain electrode 244b are respectively connected to the first source region 210b and the first drain region 210c via contact holes through the third interlayer insulating layer 242, the second gate insulating layer 238, the second interlayer insulating layer 234, the first interlayer insulating layer 218 and the first gate insulating layer 212. The first source electrode 244a is connected to the first capacitor electrode 216 via a contact hole through the third interlayer insulating layer 242, the second gate insulating layer 238, the second interlayer insulating layer 234 and the first interlayer insulating layer 218.

The second source electrode 246a and the second drain electrode 246b are respectively connected to the second source region 236b and the second drain region 236c via contact holes through the third interlayer insulating layer 242 and the second gate insulating layer 238. The second source electrode 246a is connected to the second capacitor electrode 230 via a contact hole through the third interlayer insulating layer 242, the second gate insulating layer 238 and the second interlayer insulating layer 234.

The first source and drain electrodes 244a and 244b and the second source and drain electrodes 246a and 246b may be disposed on the same or substantially same layer and formed of the same or substantially same material. For example, each of the first source and drain electrodes 244a and 244b and the second source and drain electrodes 246a and 246b may be formed of a metallic material, e.g., Mo, Al, Cr, Au, Ti, Ni, Nd, Cu or their alloy, and have a single-layered structure or a multi-layered structure.

The first semiconductor layer 210, the first gate electrode 214, the first source electrode 244a and the first drain electrode 244b constitute a first TFT T1, and the second semiconductor layer 236, the second gate electrode 240, the second source electrode 246a and the second drain electrode 246b constitute a second TFT T2. For example, the first TFT T1 may be a switching TFT, and the second TFT T2 may be a driving TFT. In addition, the first and second capacitor electrodes 216 and 230 constitute a storage capacitor.

The organic light emitting display device 200 of the present disclosure includes the first and second TFTs T1 and T2. Each of the first semiconductor layer 210 of the first TFT T1 and the second semiconductor layer 236 of the second TFT T2 may include one of a poly-semiconductor material, an amorphous semiconductor material and an oxide semiconductor material, and at least one of the first semiconductor layer 210 of the first TFT T1 and the second semiconductor layer 236 of the second TFT T2 may include the oxide semiconductor material. In an aspect of the present disclosure, the first semiconductor layer 210 of the first TFT T1 may be formed of the poly-semiconductor material, e.g., polycrystalline silicon, and the second semiconductor layer 236 of the second TFT T2 may be formed of the oxide semiconductor material.

In FIG. 5, the first gate electrode 214, the first source electrode 244a and first drain electrode 244b are disposed over the first semiconductor layer 210, and the second gate electrode 240, the second source electrode 246a and the second drain electrode 246b are disposed over the second semiconductor layer 236. For example, each of the first and second TFTs T1 and T2 has a coplanar structure. Alternatively, in each of the first and second TFTs T1 and T1, a gate electrode may be disposed under a semiconductor layer, and a source electrode and a drain electrode may be disposed over the semiconductor layer. For example, each of the TFTs T1 and T2 may have an inverted-staggered structure.

A first planarization layer 250 covering the first source and drain electrodes 244a and 244b and the second source and drain electrodes 246a and 246b is disposed on the third interlayer insulating layer 242.

The first planarization layer 250 may be formed of an organic insulating material, e.g., photo-aryl or BCB.

The first planarization layer 250 may include a lower planarization layer 250a on the first source and drain electrodes 244a and 244b and the second source and drain electrodes 246a and 246b and a upper planarization layer 250b on the lower planarization layer 250a.

A connection electrode 248 corresponding to the second source electrode 246a is disposed on the lower planarization layer 250a. The connection electrode 248 may connected to the second source electrode 246a through a contact hole in the lower planarization layer 250a. For example, the connection electrode 248 may be formed of a metallic material, e.g., Mo, Al, Cr, Au, Ti, Ni, Nd, Cu or their alloy, and have a single-layered structure or a multi-layered structure.

The upper planarization layer 250b is disposed on the lower planarization layer 250a to cover the connection electrode 248, and a first electrode 260a is disposed on the upper planarization layer 250b. The first electrode 260a corresponds to the connection electrode 248 and is connected to the connection electrode 248 through a contact hole in the upper planarization layer 250b.

For example, the first electrode 260a is separately formed in each pixel region P. The first electrode 260a may be an anode and may include a transparent conductive oxide (TCO) layer, which is formed of a conductive material, e.g., a transparent conductive oxide material, having a relatively high work function, and a reflective layer.

For example, the transparent conductive oxide material may include at least one of indium-tin-oxide (ITO), indium-zinc-oxide (IZO), indium-tin-zinc oxide (ITZO), tin oxide (SnO), zinc oxide (ZnO), indium-copper-oxide (ICO) and aluminum-zinc-oxide (Al:ZnO, AZO), and the reflective layer may include at least one of silver (Ag), an alloy of Ag and one of palladium (Pd), Cu, In and Nd and aluminum-palladium-copper alloy (APC). For example, the first electrode 260a may have a double-layered structure of Ag/ITO or APC/ITO or a triple-layered structure of ITO/Ag/ITO or ITO/APC/ITO.

A bank 256 is formed on the upper planarization layer 250b at a boundary of the pixel region. The bank 256 covers an edge of the first electrode 260a and has a first opening to expose a center of the first electrode 260a. The bank 256 may extend into a portion of the non-display area NDA. The bank 256 may include a light-absorbing particle, e.g., a black particle, to have a light-absorbing property.

A first dam DAM1 and a second dam DAM2 are disposed in the non-display area NDA. Each of the first and second dams DAM1 and DAM2 has a closed rectangular ring shape surrounding the display area DA.

The first dam DAM1 is positioned between the display area DA and the second dam DAM2. Each of the second dam DAM2 and a portion of the first dam DAM1 may be positioned on the first buffer layer 206, and the other portion of the first dam DAM1 may be positioned on the signal line 209.

The bank 256, the first dam DAM1 and the second dam DAM2 may be formed of the same or substantially same material and disposed on the same or substantially same layer. For example, each of the bank 256, the first dam DAM1 and the second DAM2 may be formed of an organic insulating material, e.g., photo-acryl, BCB or polyimide.

A spacer 258 is disposed on the bank 256. For example, the spacer 258 may be formed of an organic insulating material, e.g., photo-acryl or BCB, and have a single-layered structure or a multi-layered structure. The spacer 258 may be omitted.

An organic light emitting layer 260b covering the first electrode 260a and the bank 256 is disposed. The organic light emitting layer 260b contacts the first electrode 260a in the first opening of the bank 256. For example, the organic light emitting layer 260b may be formed to contact an upper surface of the first electrode 260a and a side surface and an upper surface of the bank 256.

For example, the organic light emitting layer 260b may include an emitting material layer (EML) including a host and a dopant. In addition, the organic light emitting layer 260b may further include at least one of a hole injection layer (HIL), a hole transporting layer (HTL), an electron blocking layer (EBL), a hole blocking layer (HBL), an electron transporting layer (ETL) and an electron injection layer (EIL) to have a multi-layered structure.

A second electrode 260c is formed over the substrate 202 where the organic emitting layer 260b is formed. The second electrode 260c covers an entire surface of the display area. The second electrode 260c may be formed of at least one of ITO, IZO, Al, Ag, Cu, Pb, magnesium (Mg), Mo, Ti and their alloy and have a single-layered structure or a multi-layered structure. The second electrode 260c may have a thin profile (small thickness) to provide a light transmittance property (or a semi-transmittance property).

The first electrode 260a, the organic light emitting layer 260b and the second electrode 260c constitute a light emitting diode D. The light emitting diode D may emit the red, green and blue light in the red, green and blue pixel region, respectively.

In the organic light emitting display device 200, the light from the organic light emitting layer 260b passes through the second electrode 260c to display an image. For example, the organic light emitting display device 200 of the present disclosure is a top-emission type display device.

An encapsulation layer (or encapsulation film) 262 is formed on the second electrode 260c to reduce or prevent penetration of moisture into the light emitting diode D. The encapsulation layer 262 may cover an entire substrate 202. The encapsulation layer 262 includes a first inorganic insulating layer 262a, an organic insulating layer 262b and a second inorganic insulating layer 262c sequentially stacked, but it is not limited thereto.

Each of the first and second inorganic insulating layers 262a and 262c may be formed of an inorganic insulating material, e.g., silicon oxide or silicon nitride. The organic insulating layer 262b may be formed of an organic insulating material, e.g., acryl resin, epoxy resin, phenolic resin, polyamide resin or polyimide resin.

The organic insulating layer 262b may be formed in an area surrounding the first dam DAM1. Each of the first and second inorganic insulating layers 262a and 262c may cover the first and second dams DAM1 and DAM2 and be formed on an entire substrate 202. Accordingly, a side of the organic insulating layer 262b may be covered with the second inorganic insulating layer 262c.

The organic insulating layer 262b is spaced apart from the first dam DAM1. A space between the organic insulating layer 262b and the first dam DMA1 may be defined as a trench structure B.

A second buffer layer 264 is disposed on the encapsulating layer 262. The second buffer layer 264 may serve as blocking external moisture and/or oxygen. The second buffer layer 264 may be formed of an inorganic insulating material, e.g., silicon oxide or silicon nitride, and have a single-layered structure or a multi-layered structure.

A bridge pattern 266 is disposed on the second buffer layer 264. The bridge pattern 266 may correspond to a boundary of the pixel region P. For example, the bridge pattern 266 may be formed of one of ITO, IZO, Al, Ag, Cu, Pb, Mg, Mo, Ti and their alloy and have a single-layered structure or a multi-layered structure.

When the second buffer layer 264 is omitted, the bridge pattern 266 may be formed directly on the encapsulation layer 262.

A black matrix 268 covering the bridge pattern 266 is disposed on the second buffer layer 264. The black matrix 268 corresponds to a space between adjacent light emitting diodes D. For example, the black matrix 268 may correspond to a boundary of the pixel region P. The bank 256 may have a first opening corresponding to the pixel region, and the black matrix 268 may have a second opening, which is greater than the first opening, corresponding to the pixel region.

Although not shown, a color filter layer corresponding to the pixel region may be disposed on the second buffer layer 264.

The organic interlayer insulating layer 270 is disposed on an entire substrate 202 to cover the black matrix 268. The organic interlayer insulating layer 270 may be formed of an organic insulating material, e.g., photo-acryl or benzocyclobutene (BCB), and have a single-layered structure or a multi-layered structure.

A touch electrode 272 corresponding to the display area DA is disposed on the organic interlayer insulating layer 270. The touch electrode 272 may correspond to a boundary of the pixel region P. The touch electrode 272 may be positioned to correspond to the black matrix 268. The touch electrode 272 may be connected to the bridge pattern 266 through a contact hole in the organic interlayer insulating layer 270 and the black matrix 268.

For example, the touch electrode 272 may be formed of one of ITO, IZO, Al, Ag, Cu, Pb, Mg, Mo, Ti and their alloy and have a single-layered structure or a multi-layered structure.

An inorganic insulating layer 274 is disposed on the touch electrode 272. The inorganic insulating layer 274 may be formed of an inorganic insulating material, e.g., silicon oxide or silicon nitride, and have a single-layered structure or a multi-layered structure. The inorganic insulating layer 274 may have an area being smaller than the substrate 202 to expose a portion of the organic interlayer insulating layer 270 at an edge of the substrate 202.

The plurality of lenses 280 are disposed on the inorganic insulating layer 274. Each lens 280 may correspond to the pixel region P. For example, one end of each lens 280 may correspond to at least one of the bridge pattern 266, the black matrix 268 and the touch electrode 272 at one side of the pixel region, and the other end of each lens 280 may correspond to at least one of the bridge pattern 266, the black matrix 268 and the touch electrode 272 at the other one side of the pixel region.

Each lens 280 may have a shape of a rod shape having curved two ends, a rectangular shape or a circular shape in a plane view. In an aspect of the present disclosure, each lens 280 may have a shape of a rod shape having curved two ends or a rectangular shape in a plane view so that a viewing angle can be controlled. Since at least one of the bridge pattern 266, the black matrix 268 and the touch electrode 272 is positioned to correspond to an end of the lens 280, i.e., a boundary of the pixel region P, the control of the viewing angle by the lens 280 can be further improved.

The stopper 282 is disposed on the inorganic insulating layer 274. The stopper 282 can serve as a dam for a solution for forming a second planarization layer 284.

In addition, a third dam DAM3 is disposed on the organic interlayer insulating layer 270 exposed by the inorganic insulating layer 274.

A flatness-enhancing pattern 290 is disposed on the inorganic insulating layer 274 and in the non-display area NDA. The flatness-enhancing pattern 290 reduces or prevents the solution for forming the second planarization layer 284 from accumulating in front of the stopper 282 so that the flatness of the second planarization layer 284 can be improved.

The flatness-enhancing pattern 290 is positioned between the display area DA and the stopper 282, and the stopper 282 is positioned between the third dam DAM3 and the flatness-enhancing pattern 290. The flatness-enhancing pattern 290 may be positioned to be closer to the stopper 282 than the display area DA. For example, the flatness-enhancing pattern 290 may have a first distance d1 from the display area DA and a second distance d2, which is smaller than the first distance d1, from the stopper 282.

The lenses 280, the flatness-enhancing pattern 290, the stopper 282 and the third dam DAM3 may be formed of the same or substantially same material. For example, each of the lenses 280, the flatness-enhancing pattern 290, the stopper 282 and the third dam DAM3 may be formed of an organic insulating material, e.g., acryl resin, epoxy resin, phenolic resin, polyamide resin or polyimide resin.

The flatness-enhancing pattern 290 includes a plurality of convex patterns spaced apart from each other. For example, the plurality of convex patterns may be spaced apart from each other along a first direction X and a second direction Y, which is perpendicular to the first direction X. A surface area of the inorganic insulating layer 274 in the non-display area NDA is increased by the plurality of convex patterns. A capillary phenomenon can be generated by a space between adjacent flatness-enhancing pattern 290. Accordingly, a spreading speed of the solution for forming the second planarization layer 284 toward the stopper 282 can be increased by the flatness-enhancing pattern 290, and the protruding limitation of the second planarization layer 284 in the front area A (of FIG. 3) of the stopper 282 can be prevented, reduced, or minimized.

Each of the stopper 282 and the third dam DAM3 has a closed rectangular ring shape surrounding the display area DA, and the plurality of convex patterns of the flatness-enhancing pattern 290 are spaced apart from each other. A space between adjacent convex patterns may act as a flow path of the solution for forming the second planarization layer 284.

In FIG. 4, two stopper 282, which are spaced apart from each other, are shown. Alternatively, one or at least three stopper 282 can be disposed.

The inorganic insulating layer 274 may be surface-treated so that the spreading speed of the solution for forming the second planarization layer 284 may be further increased. For example, a plasma treatment using an oxygen gas may be performed onto the inorganic insulating layer 274. In this case, it is preferred not to perform the surface-treatment (e.g., the plasma-treatment) on the third dam DAM3.

The non-display area NDA may include a first non-display area NDA1 disposed at the first direction X to the display area DA, a second non-display area NDA2 disposed at the second direction Y to the display area DA and a third non-display area NDA3 disposed between the first and second non-display areas NDA1 and NDA2. For example, the third non-display area NDA3 may correspond to a corner of the display area DA. The flatness-enhancing pattern 290 including the plurality of convex patterns may be disposed in the first to third non-display areas NDA1, NDA2 and NDA3.

Each convex pattern 290 has a first height, and each lens 280 has a second height being greater than the first height. In addition, each stopper 282 may have a third height being greater than the first height and equal to or smaller than the second height.

The lenses 280, the flatness-enhancing pattern 290, the stopper 282 are disposed on the inorganic insulating layer 274. Alternatively, the inorganic insulating layer 274 is omitted, the lenses 280, the flatness-enhancing pattern 290, the stopper 282 may be disposed on the organic interlayer insulating layer 270.

The second planarization layer 284 covering and planarizing the lenses 280 is disposed over the substrate 202. The second planarization layer 284 may be formed of an organic insulating material, e.g., acryl resin, epoxy resin, phenolic resin, polyamide resin or polyimide resin. The organic insulating material of the lens 280 has a first refractive index, and the organic insulating material of the second planarization layer 284 has a second refractive index being smaller than the first refractive index.

The second planarization layer 284 may be disposed in an area surrounded by the third dam DAM3 to cover the lenses 280, the flatness-enhancing pattern 290 and the stopper 282. Alternatively, the second planarization layer 284 may be disposed in an area surrounded by the stopper 282 to cover the lenses 280 and the flatness-enhancing pattern 290.

The trench structure B serves as a buffer for controlling a flow of a solution for forming the second planarization layer 284. The second planarization layer 284 in the trench structure B, i.e., a space between the organic insulating layer 262b of the encapsulation layer 262 and the first dam DAM1, may have a thickness being greater than the second planarization layer 284 in the display area DA.

The solution for forming the second planarization layer 284 is dropped on the display area DA and then spreads toward the non-display area NDA. The spreading speed of the solution for forming the second planarization layer 284 is increased due to the flatness-enhancing pattern 290 provided between the display area DA and the stopper 282 so that the flatness of the second planarization layer 284 can be improved.

In addition, the flow of the solution for forming the second planarization layer 284 is controlled by the trench structure B, which is provided by the organic insulating layer 262b of the encapsulation layer 262 and the first dam DAM1. Accordingly, the solution for forming the second planarization layer 284 is reduced or prevented from flowing over the third dam DAM3, and the flatness of the second planarization layer 284 can be further improved.

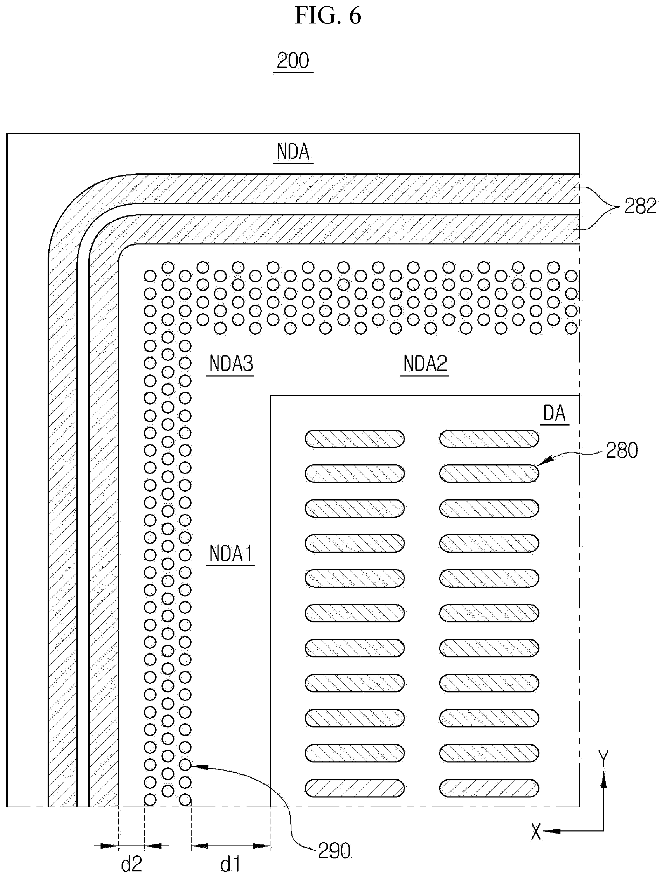

FIG. 6 is a schematic plan view illustrating a portion of an organic light emitting display device according to the second embodiment of the present disclosure.

Referring to FIG. 6 with FIGs. 4 and 5, the organic light emitting display device 200 includes the display area DA and the non-display area NDA surrounding the display area DA. The lens 280 corresponding to the pixel region P is positioned in the display area DA, and the stopper 282 and the flatness-enhancing pattern 290 are positioned in the non-display area NDA.

The lens 280, the stopper 282 and the flatness-enhancing pattern 290 may be disposed on the inorganic insulating layer 274. Alternatively, with omitting the inorganic insulating layer 274, the lens 280, the stopper 282 and the flatness-enhancing pattern 290 may be disposed on the organic interlayer insulating layer 270.

The lens 280, the flatness-enhancing pattern 290 and the stopper 282 may be formed of the same or substantially same material. For example, each of the lens 280, the flatness-enhancing pattern 290 and the stopper 282 may be formed of an organic insulating material, e.g., acryl resin, epoxy resin, phenolic resin, polyamide resin or polyimide resin.

The lens 280 may have a major axis along the first direction X and a minor axis along the second direction Y. For example, the lens 280 may have a shape of a rod shape having curved two ends or a rectangular shape in a plane view. An end of the lens 280 may overlap at least one of the black matrix 268 and the touch electrode 272.

The stopper 282 may have a rectangular ring shape surrounding the display area DA.

The flatness-enhancing pattern 290 is positioned between the display area DA and the stopper 282. The flatness-enhancing pattern 290 may be positioned to be closer to the stopper 282 than the display area DA. For example, the flatness-enhancing pattern 290 may have a first distance d1 from the display area DA and a second distance d2, which is smaller than the first distance d1, from the stopper 282.

The flatness-enhancing pattern 290 includes a plurality of convex patterns spaced apart from each other. A density of the flatness-enhancing pattern 290 may greater than that of the lens 280. For example, the plurality of convex patterns may be spaced apart from each other along a first direction X and a second direction Y, which is perpendicular to the first direction X. A surface area of the inorganic insulating layer 274 in the non-display area NDA is increased by the plurality of convex patterns. A capillary phenomenon can be generated by a space between adjacent flatness-enhancing pattern 290.

Accordingly, a spreading speed of the solution for forming the second planarization layer 284 toward the stopper 282 can be increased by the flatness-enhancing pattern 290, and the protruding limitation of the second planarization layer 284 in the front area A (of FIG. 3) of the stopper 282 can be prevented, reduced, or minimized.

Each of the stopper 282 and the third dam DAM3 has a closed rectangular ring shape surrounding the display area DA, and the plurality of convex patterns of the flatness-enhancing pattern 290 are spaced apart from each other. A space between adjacent convex patterns may act as a flow path of the solution for forming the second planarization layer 284.

The non-display area NDA includes a first non-display area NDA1 at the first direction X to the display area DA and a second non-display area NDA2 at the second direction Y to the display area DA. The plurality of convex patterns in the first non-display area NDA1 and the plurality of convex patterns in the second non-display area NDA2 may be arranged with the same or substantially same shape, the same or substantially same size and the same or substantially same density.

The non-display area NDA may further include a third non-display area NDA3 between the first and second non-display areas NDA1 and NDA2, i.e., a corner of the display area DA, and the plurality of convex patterns are disposed in the third non-display area NDA3. The plurality of convex patterns in the first to third non-display areas NDA1, NDA2 and NDA3 may be arranged with the same or substantially same shape, the same or substantially same size and the same or substantially same density.

The solution for forming the second planarization layer 284 is dropped on the display area DA and then spreads toward the non-display area NDA. The spreading speed of the solution for forming the second planarization layer 284 is increased due to the flatness-enhancing pattern 290 provided between the display area DA and the stopper 282 so that the flatness of the second planarization layer 284 can be improved.

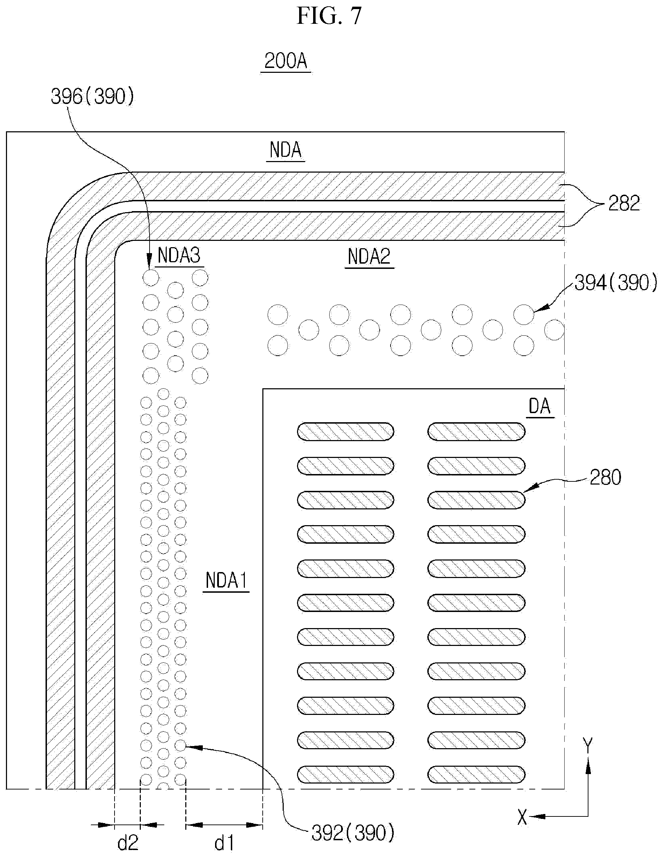

FIG. 7 is a schematic plan view illustrating a portion of an organic light emitting display device according to the second embodiment of the present disclosure.

Referring to FIG. 7 with FIGs. 4 and 5, the organic light emitting display device 200 includes the display area DA and the non-display area NDA surrounding the display area DA. The lens 280 corresponding to the pixel region P is positioned in the display area DA, and the stopper 282 and the flatness-enhancing pattern 390 are positioned in the non-display area NDA.

The lens 280, the stopper 282 and the flatness-enhancing pattern 390 may be disposed on the inorganic insulating layer 274. Alternatively, with omitting the inorganic insulating layer 274, the lens 280, the stopper 282 and the flatness-enhancing pattern 390 may be disposed on the organic interlayer insulating layer 270.

The lens 280, the flatness-enhancing pattern 390 and the stopper 282 may be formed of the same or substantially same material. For example, each of the lens 280, the flatness-enhancing pattern 390 and the stopper 282 may be formed of an organic insulating material, e.g., acryl resin, epoxy resin, phenolic resin, polyamide resin or polyimide resin.

The lens 280 may have a major axis along the first direction X and a minor axis along the second direction Y. For example, the lens 280 may have a shape of a rod shape having curved two ends or a rectangular shape in a plane view. An end of the lens 280 may overlap at least one of the black matrix 268 and the touch electrode 272.

The stopper 282 may have a rectangular ring shape surrounding the display area DA. FIG. 7 shows two stoppers 282 being spaced apart from each other. Alternatively, one or at least three stopper 282 may be disposed.

The flatness-enhancing pattern 390 is positioned between the display area DA and the stopper 282. The flatness-enhancing pattern 390 may be positioned to be closer to the stopper 282 than the display area DA. For example, the flatness-enhancing pattern 390 may have a first distance d1 from the display area DA and a second distance d2, which is smaller than the first distance d1, from the stopper 282.

The flatness-enhancing pattern 390 includes a plurality of convex patterns spaced apart from each other. For example, the plurality of convex patterns may be spaced apart from each other along a first direction X and a second direction Y, which is perpendicular to the first direction X. A surface area of the inorganic insulating layer 274 in the non-display area NDA is increased by the plurality of convex patterns. A capillary phenomenon can be generated by a space between adjacent flatness-enhancing pattern 390. Accordingly, a spreading speed of the solution for forming the second planarization layer 284 toward the stopper 282 can be increased by the flatness-enhancing pattern 390, and the protruding limitation of the second planarization layer 284 in the front area A (of FIG. 3) of the stopper 282 can be prevented, reduced, or minimized.

Each of the stopper 282 and the third dam DAM3 has a closed rectangular ring shape surrounding the display area DA, and the plurality of convex patterns of the flatness-enhancing pattern 390 are spaced apart from each other. A space between adjacent convex patterns may act as a flow path of the solution for forming the second planarization layer 284.

The non-display area NDA includes a first non-display area NDA1 at the first direction X to the display area DA and a second non-display area NDA2 at the second direction Y to the display area DA.

The flatness-enhancing pattern 390 includes a plurality of first flatness-enhancing patterns 392 (e.g., a plurality of first convex patterns) in the first non-display area NDA1 and a plurality of second flatness-enhancing pattern 394 (e.g., a plurality of second convex patterns) in the second non-display area NDA2. The first flatness-enhancing pattern 392 has a first density (e.g., a spatial frequency), and the second flatness-enhancing pattern 394 has a second density being smaller than the first density.

The non-display area NDA may further include a third non-display area NDA3 between the first and second non-display areas NDA1 and NDA2, i.e., a corner of the display area DA. The flatness-enhancing pattern 390 may further include a plurality of third flatness-enhancing patterns 396 (e.g., a plurality of third convex patterns) in the third non-display area NDA3. The third flatness-enhancing pattern 396 may have a third density being smaller than the first density and greater than the second density.

The first to third flatness-enhancing patterns 392, 394 and 396 have the same or substantially same shape. The third flatness-enhancing pattern 396 may have a size being greater than the first flatness-enhancing pattern 392 and smaller than the second flatness-enhancing pattern 394. For example, the first to third flatness-enhancing patterns 392, 394 and 396 may have the same or substantially same shape and a difference in the density and the size.

In an aspect of the present disclosure, the first to third flatness-enhancing pattern 392, 394 and 396 may have the same or substantially same area. For example, the first to third flatness-enhancing patterns 392, 394 and 396 may have the same or substantially same shape and the same or substantially same size and a difference in the density.

The solution for forming the second planarization layer 284 is dropped on the display area DA and then spreads toward the non-display area NDA. The spreading speed of the solution for forming the second planarization layer 284 is increased due to the flatness-enhancing pattern 390 provided between the display area DA and the stopper 282 so that the flatness of the second planarization layer 284 can be improved.

In addition, since the lens 280 has a major axis along the first direction X and a minor axis along the second direction Y, the spreading speed of the solution for forming the second planarization layer 284 is faster in the first direction X than the second direction Y being perpendicular to the first direction X and a third direction being inclined to the first and second directions X and Y. Accordingly, by arranging the first flatness-enhancing pattern 392 in the first non-display area NDA1 to be denser than the second flatness-enhancing pattern 394 in the second non-display area NDA2 and the third flatness-enhancing pattern 396 in the third non-display area NDA3, the flatness of the second planarization layer 284 can be further improved.

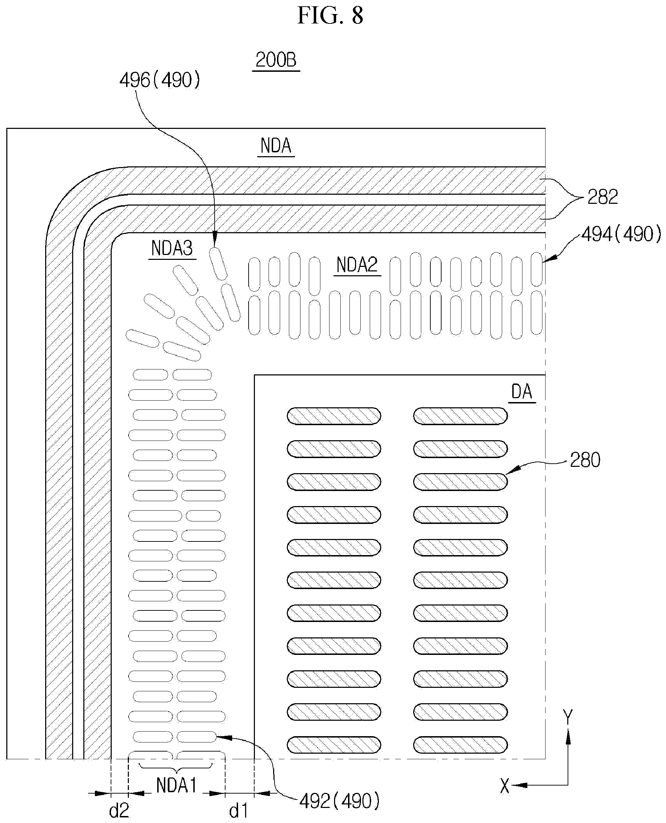

FIG. 8 is a schematic plan view illustrating a portion of an organic light emitting display device according to the second embodiment of the present disclosure.

Referring to FIG. 8 with FIGs. 4 and 5, the organic light emitting display device 200 includes the display area DA and the non-display area NDA surrounding the display area DA. The lens 280 corresponding to the pixel region P is positioned in the display area DA, and the stopper 282 and the flatness-enhancing pattern 490 are positioned in the non-display area NDA.

The lens 280, the stopper 282 and the flatness-enhancing pattern 490 may be disposed on the inorganic insulating layer 274. Alternatively, with omitting the inorganic insulating layer 274, the lens 280, the stopper 282 and the flatness-enhancing pattern 490 may be disposed on the organic interlayer insulating layer 270.

The lens 280, the flatness-enhancing pattern 490 and the stopper 282 may be formed of the same or substantially same material. For example, each of the lens 280, the flatness-enhancing pattern 490 and the stopper 282 may be formed of an organic insulating material, e.g., acryl resin, epoxy resin, phenolic resin, polyamide resin or polyimide resin.

The lens 280 may have a major axis along the first direction X and a minor axis along the second direction Y. For example, the lens 280 may have a shape of a rod shape having curved two ends or a rectangular shape in a plane view. An end of the lens 280 may overlap at least one of the black matrix 268 and the touch electrode 272.

The stopper 282 may have a rectangular ring shape surrounding the display area DA. FIG. 8 shows two stoppers 282 being spaced apart from each other. Alternatively, one or at least three stopper 282 may be disposed.

The flatness-enhancing pattern 490 is positioned between the display area DA and the stopper 282. The flatness-enhancing pattern 490 may be positioned to be closer to the stopper 282 than the display area DA. For example, the flatness-enhancing pattern 490 may have a first distance d1 from the display area DA and a second distance d2, which is smaller than the first distance d1, from the stopper 282.

The flatness-enhancing pattern 490 includes a plurality of convex patterns spaced apart from each other. For example, the plurality of convex patterns may be spaced apart from each other along a first direction X and a second direction Y, which is perpendicular to the first direction X. A surface area of the inorganic insulating layer 274 in the non-display area NDA is increased by the plurality of convex patterns. A capillary phenomenon can be generated by a space between adjacent flatness-enhancing pattern 490. Accordingly, a spreading speed of the solution for forming the second planarization layer 284 toward the stopper 282 can be increased by the flatness-enhancing pattern 490, and the protruding limitation of the second planarization layer 284 in the front area A (of FIG. 3) of the stopper 282 can be prevented, reduced, or minimized.

Each of the stopper 282 and the third dam DAM3 has a closed rectangular ring shape surrounding the display area DA, and the plurality of convex patterns of the flatness-enhancing pattern 490 are spaced apart from each other. A space between adjacent convex patterns may act as a flow path of the solution for forming the second planarization layer 284.

The non-display area NDA includes a first non-display area NDA1 at the first direction X to the display area DA and a second non-display area NDA2 at the second direction Y to the display area DA.

The flatness-enhancing pattern 490 includes a plurality of first flatness-enhancing patterns 492 (e.g., a plurality of first convex patterns) in the first non-display area NDA1 and a plurality of second flatness-enhancing pattern 494 (e.g., a plurality of second convex patterns) in the second non-display area NDA2. The first flatness-enhancing pattern 492 has a major axis along the first direction X and a minor axis along the second direction Y, and the second flatness-enhancing pattern 494 has a major axis along the second direction Y and a minor axis along the first direction X.

The non-display area NDA may further include a third non-display area NDA3 between the first and second non-display areas NDA1 and NDA2, i.e., a corner of the display area DA. The flatness-enhancing pattern 490 may further include a plurality of third flatness-enhancing patterns 496 (e.g., a plurality of third convex patterns) in the third non-display area NDA3. The third flatness-enhancing pattern 496 may have a major axis along a third direction toward the display area DA among the directions crossing the first and second directions X and Y and a minor axis along a fourth direction crossing the first direction X, the second direction Y and the third direction. The fourth direction may be perpendicular to the third direction.

The first to third flatness-enhancing patterns 492, 494 and 496 have the same or substantially same shape, the same or substantially same area (i.e., a size) and the same or substantially same density and a difference in an arranging direction.

In an aspect of the present disclosure, the first to third flatness-enhancing patterns 492, 494 and 496 may be identical in at least one of the shape, the area and the density and have a difference in arranging direction.

The solution for forming the second planarization layer 284 is dropped on the display area DA and then spreads toward the non-display area NDA. The spreading speed of the solution for forming the second planarization layer 284 is increased due to the flatness-enhancing pattern 490 provided between the display area DA and the stopper 282 so that the flatness of the second planarization layer 284 can be improved.

In addition, since the lens 280 has a major axis along the first direction X and a minor axis along the second direction Y, the spreading speed of the solution for forming the second planarization layer 284 is faster in the first direction X than the second direction Y being perpendicular to the first direction X and a third direction being inclined to the first and second directions X and Y. Accordingly, by arranging the first flatness-enhancing pattern 492 in the first non-display area NDA1, the second flatness-enhancing pattern 494 in the second non-display area NDA2 and the third flatness-enhancing pattern 496 in the third non-display area NDA3 along different directions, the flatness of the second planarization layer 284 can be further improved.

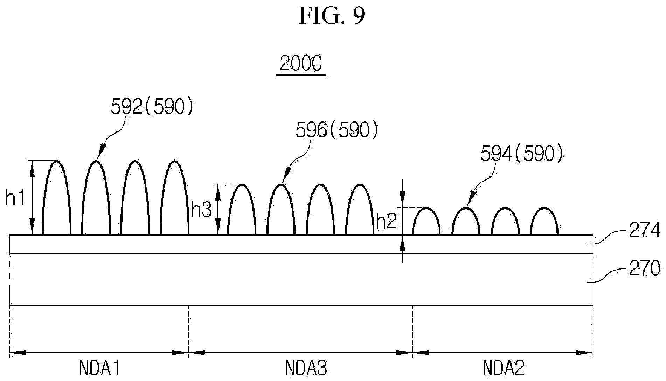

FIG. 9 is a schematic plan view illustrating a portion of an organic light emitting display device according to the second embodiment of the present disclosure.

Referring to FIG. 9 with FIGs. 4 and 5, the organic light emitting display device 200 includes the display area DA and the non-display area NDA surrounding the display area DA. The lens 280 corresponding to the pixel region P is positioned in the display area DA, and the stopper 282 and the flatness-enhancing pattern 590 are positioned in the non-display area NDA.

The lens 280, the stopper 282 and the flatness-enhancing pattern 590 may be disposed on the inorganic insulating layer 274. Alternatively, with omitting the inorganic insulating layer 274, the lens 280, the stopper 282 and the flatness-enhancing pattern 590 may be disposed on the organic interlayer insulating layer 270.

The lens 280, the flatness-enhancing pattern 590 and the stopper 282 may be formed of the same or substantially same material. For example, each of the lens 280, the flatness-enhancing pattern 590 and the stopper 282 may be formed of an organic insulating material, e.g., acryl resin, epoxy resin, phenolic resin, polyamide resin or polyimide resin.

The lens 280 may have a major axis along the first direction X and a minor axis along the second direction Y. For example, the lens 280 may have a shape of a rod shape having curved two ends or a rectangular shape in a plane view. An end of the lens 280 may overlap at least one of the black matrix 268 and the touch electrode 272.

The flatness-enhancing pattern 590 is positioned between the display area DA and the stopper 282. The flatness-enhancing pattern 590 may be positioned to be closer to the stopper 282 than the display area DA. For example, the flatness-enhancing pattern 590 may have a first distance d1 from the display area DA and a second distance d2, which is smaller than the first distance d1, from the stopper 282.

The flatness-enhancing pattern 590 includes a plurality of convex patterns spaced apart from each other. For example, the plurality of convex patterns may be spaced apart from each other along a first direction X and a second direction Y, which is perpendicular to the first direction X. A surface area of the inorganic insulating layer 274 in the non-display area NDA is increased by the plurality of convex patterns. A capillary phenomenon can be generated by a space between adjacent flatness-enhancing pattern 590. Accordingly, a spreading speed of the solution for forming the second planarization layer 284 toward the stopper 282 can be increased by the flatness-enhancing pattern 590, and the protruding limitation of the second planarization layer 284 in the front area A (of FIG. 3) of the stopper 282 can be prevented, reduced, or minimized.

Each of the stopper 282 and the third dam DAM3 has a closed rectangular ring shape surrounding the display area DA, and the plurality of convex patterns of the flatness-enhancing pattern 590 are spaced apart from each other. A space between adjacent convex patterns may act as a flow path of the solution for forming the second planarization layer 284.

The non-display area NDA includes a first non-display area NDA1 at the first direction X to the display area DA and a second non-display area NDA2 at the second direction Y to the display area DA.

The flatness-enhancing pattern 590 includes a plurality of first flatness-enhancing patterns 592 (e.g., a plurality of first convex patterns) in the first non-display area NDA1 and a plurality of second flatness-enhancing pattern 594 (e.g., a plurality of second convex patterns) in the second non-display area NDA2. The first flatness-enhancing pattern 592 has a first height h1, and the second flatness-enhancing pattern 594 has a second height h2 being smaller than the first height h1.

The non-display area NDA may further include a third non-display area NDA3 between the first and second non-display areas NDA1 and NDA2, i.e., a corner of the display area DA. The flatness-enhancing pattern 590 may further include a plurality of third flatness-enhancing patterns 596 (e.g., a plurality of third convex patterns) in the third non-display area NDA3. The third flatness-enhancing pattern 596 may have a third height h3 being smaller than the first height h1 and greater than the second height h2.

The first to third flatness-enhancing patterns 592, 594 and 596 have the same or substantially same shape, the same or substantially same area (i.e., a size) and the same or substantially same density and a difference in a height.

In an aspect of the present disclosure, the first to third flatness-enhancing patterns 592, 594 and 596 may be identical in at least one of the shape, the area and the density and have a difference in height.

The solution for forming the second planarization layer 284 is dropped on the display area DA and then spreads toward the non-display area NDA. The spreading speed of the solution for forming the second planarization layer 284 is increased due to the flatness-enhancing pattern 590 provided between the display area DA and the stopper 282 so that the flatness of the second planarization layer 284 can be improved.

In addition, since the lens 280 has a major axis along the first direction X and a minor axis along the second direction Y, the spreading speed of the solution for forming the second planarization layer 284 is faster in the first direction X than the second direction Y being perpendicular to the first direction X and a third direction being inclined to the first and second directions X and Y. Accordingly, by increasing the first flatness-enhancing pattern 592 in the first non-display area NDA1 to be higher than the second flatness-enhancing pattern 594 in the second non-display area NDA2 and the third flatness-enhancing pattern 596 in the third non-display area NDA3, the flatness of the second planarization layer 284 can be further improved.

Referring to FIGs. 7 to 9, the flatness-enhancing pattern 390, 490 and 590 including a convex pattern includes a first flatness-enhancing pattern 392, 492 and 592 disposed in the first non-display area NDA1 at the first direction X from the display area DA, a second flatness-enhancing pattern 394, 494 and 594 disposed in the second non-display area NDA2 at the second direction Y from the display area DA and a third flatness-enhancing pattern 396, 496 and 596 disposed in the third non-display area NDA3 at a corner between the first and second non-display areas NDA1 and NDA2. The first flatness-enhancing pattern 392, 492 and 592, the second flatness-enhancing pattern 394, 494 and 594 and the third flatness-enhancing pattern 396, 496 and 596 have a difference in at least one of a density, an arranging direction and a height so that the flatness of the second planarization layer 284 in an entire surface of the organic light emitting display device 200 can be further improved.

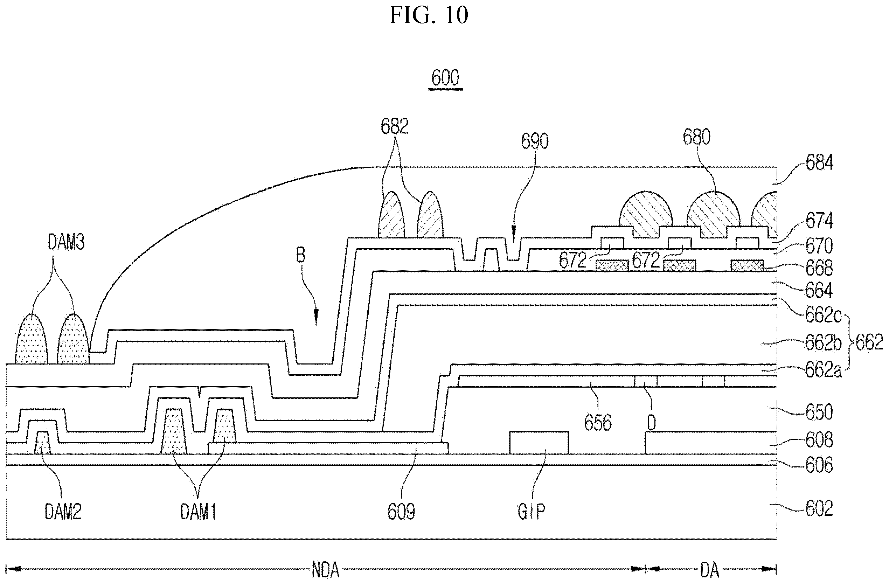

FIG. 10 is a schematic cross-sectional view illustrating an organic light emitting display device according to a third embodiment of the present disclosure.

Referring to FIG. 10, an organic light emitting display device 600 includes a substrate 602 including a display area DA and a non-display area NDA, a light emitting diode D disposed over the substrate 602 and in the display area DA, an organic interlayer insulating layer 670 disposed over the light emitting diode D, a plurality of lenses 680 disposed on the organic interlayer insulating layer 670 and in the display area DA, a stopper 682 disposed on the organic interlayer insulating layer 670 and in the non-display area NDA, a flatness enhancing pattern 690 disposed on the interlayer insulating layer 670 and in the non-display area NDA and a second planarization layer 684 covering the plurality of lenses 680, the flatness enhancing pattern 690 and the stopper 682.

A plurality of pixel regions P (of FIG. 5) are defined in the display area DA and on the substrate 602. The substrate 602 may be a glass substrate or a plastic substrate. For example, the substrate 602 may be one of polyimide (PI) substrate, polyethersulfone (PES) substrate, polyethylenenaphthalate (PEN) substrate, polyethylene terephthalate (PET) substrate and polycarbonate (PC) substrate.

In an aspect of the present disclosure, the substrate may have a triple-layered structure including a first polyimide layer, a second polyimide layer and an interlayer inorganic layer between the first and second polyimide layers. The interlayer inorganic layer may be formed of an inorganic insulating material, e.g., silicon oxide or silicon nitride.

A first buffer layer 606 is disposed on the substrate 602. A pixel circuit layer 608, a gate driving part GIP and a signal line 609 are disposed on the first buffer layer 606. The pixel circuit layer 608 corresponds to the display area DA, and the gate driving part GIP and the signal line 609 correspond to the non-display area NDA. The gate driving part GIP may be positioned between the display area DA and the signal line 609.

The pixel circuit layer 608 includes a first TFT T1 and a second TFT T2. The pixel circuit layer 608 may further include a storage capacitor.

Referring to FIG. 10 with FIG. 5, a first light shielding pattern 204 is disposed on the substrate 602. The light through the substrate 604 can be blocked by the first light shielding pattern 204. For example, the first light shielding pattern 204 may be formed of a metallic material, e.g., molybdenum (Mo), aluminum (Al), chromium (Cr), gold (Au), titanium (Ti), nickel (Ni), neodymium (Nd), copper (Cu) or their alloy, and have a single-layered structure or a multi-layered structure.

A first buffer layer 606 covering the first light shielding pattern 204 is disposed over the substrate 602. The moisture and/or oxygen can be blocked by the first buffer layer 606.

A first semiconductor layer 210 corresponding to the first light shielding pattern 204 is disposed on the first buffer layer 606. The first semiconductor layer 210 may include one of a poly-semiconductor material, an amorphous semiconductor material and an oxide semiconductor material.

In an aspect of the present disclosure, the first semiconductor layer 210 may be formed of a poly-semiconductor material, e.g., polycrystalline silicon. The first semiconductor layer 210 may include a first channel region 210a, a first source region 210b at one side of the first channel region 210a and a first drain region 210c at the other side of the first channel region 210a. Impurities may be dopped into the first source and drain regions 210b and 210c.

A gate driving part GIP and a signal line 209 are disposed on the first buffer layer 606 and in the non-display area NDA. The gate driving part GIP may be positioned between the display area DA and the signal line 610. The signal line 209 may include a low potential signal line for providing a low potential signal (Vss).

A first gate insulating layer 212 covering the first semiconductor layer 210 is disposed over the first buffer layer 606, and a first gate electrode 214 corresponding to the first channel region 210a of the first semiconductor layer 210 is disposed on the first gate insulating layer 212. In addition, a first capacitor electrode 216, which is spaced apart from the first gate electrode 214, is disposed on the first gate insulating layer 212.

A first interlayer insulating layer 218 covering the first gate electrode 214 and the first capacitor electrode 216 is disposed on the first gate insulating layer 212, and a second capacitor electrode 230 corresponding to the first capacitor electrode 216 and a second light shielding pattern 232 spaced apart from the second capacitor electrode 230 are disposed on the first interlayer insulating layer 218.

A second interlayer insulating layer 234 covering the second capacitor electrode 230 and the second light shielding pattern 232 is disposed on the first interlayer insulating layer 218, and a second semiconductor layer 236 corresponding to the second light shielding pattern 232 is disposed on the second interlayer insulating layer 234. The second semiconductor layer 236 may include one of a poly-semiconductor material, an amorphous semiconductor material and an oxide semiconductor material.

In an aspect of the present disclosure, the second semiconductor layer 236 may be formed of an oxide semiconductor material, e.g., indium-gallium-zinc oxide (IGZO), zinc oxide (ZnO), tin oxide (SnO2), copper oxide (Cu2O), nickel oxide (NiO), indium-tin-zinc oxide (ITZO) or indium-aluminum-zinc oxide (IAZO). The second semiconductor layer 236 may include a second channel region 236a, a second source region 236b at one side of the second channel region 236a and a second drain region 236c at the other side of the second channel region 236a. Impurities may be dopped into the second source and drain regions 236b and 236c.

A second gate insulating layer 238 covering the second semiconductor layer 236 is disposed over the second interlayer insulating layer 234, and a second gate electrode 240 corresponding to the second channel region 236a of the second semiconductor layer 236 is disposed on the second gate insulating layer 238.

A third interlayer insulating layer 242 covering the second gate electrode 240 is disposed on the second gate insulating layer 238, and a first source electrode 244a, a first drain electrode 244b, a second source electrode 246a and a second drain electrode 246b are disposed on the third interlayer insulating layer 242.

The first source electrode 244a and the first drain electrode 244b are respectively connected to the first source region 210b and the first drain region 210c via contact holes through the third interlayer insulating layer 242, the second gate insulating layer 238, the second interlayer insulating layer 234, the first interlayer insulating layer 218 and the first gate insulating layer 212. The first source electrode 244a is connected to the first capacitor electrode 216 via a contact hole through the third interlayer insulating layer 242, the second gate insulating layer 238, the second interlayer insulating layer 234 and the first interlayer insulating layer 218.

The second source electrode 246a and the second drain electrode 246b are respectively connected to the second source region 236b and the second drain region 236c via contact holes through the third interlayer insulating layer 242 and the second gate insulating layer 238. The second source electrode 246a is connected to the second capacitor electrode 230 via a contact hole through the third interlayer insulating layer 242, the second gate insulating layer 238 and the second interlayer insulating layer 234.

The first semiconductor layer 210, the first gate electrode 214, the first source electrode 244a and the first drain electrode 244b constitute a first TFT T1, and the second semiconductor layer 236, the second gate electrode 240, the second source electrode 246a and the second drain electrode 246b constitute a second TFT T2.

The organic light emitting display device 600 of the present disclosure includes the first and second TFTs T1 and T2. Each of the first semiconductor layer 210 of the first TFT T1 and the second semiconductor layer 236 of the second TFT T2 may include one of a poly-semiconductor material, an amorphous semiconductor material and an oxide semiconductor material, and at least one of the first semiconductor layer 210 of the first TFT T1 and the second semiconductor layer 236 of the second TFT T2 may include the oxide semiconductor material. In an aspect of the present disclosure, the first semiconductor layer 210 of the first TFT T1 may be formed of the poly-semiconductor material, e.g., polycrystalline silicon, and the second semiconductor layer 236 of the second TFT T2 may be formed of the oxide semiconductor material.

A first planarization layer 650 covering the first source and drain electrodes 244a and 244b and the second source and drain electrodes 246a and 246b is disposed on the third interlayer insulating layer 242.

The first planarization layer 650 may include a lower planarization layer 250a on the first source and drain electrodes 244a and 244b and the second source and drain electrodes 246a and 246b and a upper planarization layer 250b on the lower planarization layer 250a.

A connection electrode 248 corresponding to the second source electrode 246a is disposed on the lower planarization layer 250a. The connection electrode 248 may connected to the second source electrode 246a through a contact hole in the lower planarization layer 250a.

The upper planarization layer 250b is disposed on the lower planarization layer 250a to cover the connection electrode 248, and a first electrode 260a is disposed on the upper planarization layer 250b. The first electrode 260a corresponds to the connection electrode 248 and is connected to the connection electrode 248 through a contact hole in the upper planarization layer 250b.

For example, the first electrode 260a is separately formed in each pixel region P. The first electrode 260a may be an anode and may include a transparent conductive oxide (TCO) layer, which is formed of a conductive material, e.g., a transparent conductive oxide material, having a relatively high work function, and a reflective layer.

For example, the transparent conductive oxide material may include at least one of indium-tin-oxide (ITO), indium-zinc-oxide (IZO), indium-tin-zinc oxide (ITZO), tin oxide (SnO), zinc oxide (ZnO), indium-copper-oxide (ICO) and aluminum-zinc-oxide (Al:ZnO, AZO), and the reflective layer may include at least one of silver (Ag), an alloy of Ag and one of palladium (Pd), Cu, In and Nd and aluminum-palladium-copper alloy (APC). For example, the first electrode 260a may have a double-layered structure of Ag/ITO or APC/ITO or a triple-layered structure of ITO/Ag/ITO or ITO/APC/ITO.

A bank 656 is formed on the upper planarization layer 250b at a boundary of the pixel region P. The bank 656 covers an edge of the first electrode 260a and has a first opening to expose a center of the first electrode 260a. The bank 656 may extend into a portion of the non-display area NDA. The bank 656 may include a light-absorbing particle, e.g., a black particle, to have a light-absorbing property.

A first dam DAM1 and a second dam DAM2 are disposed in the non-display area NDA. Each of the first and second dams DAM1 and DAM2 has a closed rectangular ring shape surrounding the display area DA.

A spacer 258 is disposed on the bank 656, and an organic light emitting layer 260b covering the first electrode 260a and the bank 656 is disposed.

A second electrode 260c is formed over the substrate 202 where the organic emitting layer 260b is formed. The second electrode 260c covers an entire surface of the display area. The second electrode 260c may be formed of at least one of ITO, IZO, Al, Ag, Cu, Pb, magnesium (Mg), Mo, Ti and their alloy and have a single-layered structure or a multi-layered structure. The second electrode 260c may have a thin profile (small thickness) to provide a light transmittance property (or a semi-transmittance property).

The first electrode 260a, the organic light emitting layer 260b and the second electrode 260c constitute a light emitting diode D. The light emitting diode D may emit the red, green and blue light in the red, green and blue pixel region, respectively.

In the organic light emitting display device 600, the light from the organic light emitting layer 260b passes through the second electrode 260c to display an image. For example, the organic light emitting display device 200 of the present disclosure is a top-emission type display device.

An encapsulation layer (or encapsulation film) 662 is formed on the second electrode 660c to reduce or prevent penetration of moisture into the light emitting diode D. The encapsulation layer 662 may cover an entire substrate 602. The encapsulation layer 662 includes a first inorganic insulating layer 662a, an organic insulating layer 662b and a second inorganic insulating layer 662c sequentially stacked, but it is not limited thereto.

The organic insulating layer 662b may be formed in an area surrounding the first dam DAM1. Each of the first and second inorganic insulating layers 662a and 662c may cover the first and second dams DAM1 and DAM2 and be formed on an entire substrate 602. Accordingly, a side of the organic insulating layer 662b may be covered with the second inorganic insulating layer 662c.

The organic insulating layer 662b is spaced apart from the first dam DAM1. A space between the organic insulating layer 662b and the first dam DMA1 may be defined as a trench structure B.

A second buffer layer 664 is disposed on the encapsulating layer 662, and a bridge pattern 266 is disposed on the second buffer layer 664. The bridge pattern 266 may correspond to a boundary of the pixel region P.

A black matrix 668 covering the bridge pattern 266 is disposed on the second buffer layer 664. The black matrix 668 corresponds to a space between adjacent light emitting diodes D. For example, the black matrix 668 may correspond to a boundary of the pixel region P. The bank 656 may have a first opening corresponding to the pixel region, and the black matrix 668 may have a second opening, which is greater than the first opening, corresponding to the pixel region.

Although not shown, a color filter layer corresponding to the pixel region may be disposed on the second buffer layer 664.

The organic interlayer insulating layer 670 is disposed on an entire substrate 602 to cover the black matrix 668. The organic interlayer insulating layer 670 may be formed of an organic insulating material, e.g., photo-acryl or benzocyclobutene (BCB), and have a single-layered structure or a multi-layered structure.

A touch electrode 672 corresponding to the display area DA is disposed on the organic interlayer insulating layer 670. The touch electrode 672 may correspond to a boundary of the pixel region P. The touch electrode 672 may be positioned to correspond to the black matrix 668. The touch electrode 672 may be connected to the bridge pattern 266 through a contact hole in the organic interlayer insulating layer 670 and the black matrix 668.

An inorganic insulating layer 674 is disposed on the touch electrode 672. The inorganic insulating layer 674 may be formed of an inorganic insulating material, e.g., silicon oxide or silicon nitride, and have a single-layered structure or a multi-layered structure. The inorganic insulating layer 674 may have an area being smaller than the substrate 602 to expose a portion of the organic interlayer insulating layer 670 at an edge of the substrate 602.

The plurality of lenses 680 are disposed on the inorganic insulating layer 674. Each lens 680 may correspond to the pixel region P. For example, one end of each lens 680 may correspond to at least one of the bridge pattern 266, the black matrix 668 and the touch electrode 672 at one side of the pixel region, and the other end of each lens 680 may correspond to at least one of the bridge pattern 266, the black matrix 668 and the touch electrode 672 at the other one side of the pixel region.

Each lens 680 may have a shape of a rod shape having curved two ends, a rectangular shape or a circular shape in a plane view. In an aspect of the present disclosure, each lens 680 may have a shape of a rod shape having curved two ends or a rectangular shape in a plane view so that a viewing angle can be controlled. Since at least one of the bridge pattern 266, the black matrix 668 and the touch electrode 672 is positioned to correspond to an end of the lens 680, i.e., a boundary of the pixel region P, the control of the viewing angle by the lens 680 can be further improved.

The stopper 682 is disposed on the inorganic insulating layer 674. The stopper 682 can serve as a dam for a solution for forming a second planarization layer 684.

In addition, a third dam DAM3 is disposed on the organic interlayer insulating layer 670 exposed by the inorganic insulating layer 674.

The lenses 680, the stopper 682, the third dam DAM3 may be formed of the same or substantially same material. For example, each of the lenses 680, the stopper 682, the third dam DAM3 may be formed of an organic insulating material, e.g., acryl resin, epoxy resin, phenolic resin, polyamide resin or polyimide resin.

A flatness-enhancing pattern 690 is disposed on the inorganic insulating layer 674 and in the non-display area NDA. The flatness-enhancing pattern 690 reduces or prevents the solution for forming the second planarization layer 684 from accumulating in front of the stopper 682 so that the flatness of the second planarization layer 684 can be improved.

The flatness-enhancing pattern 690 is positioned between the display area DA and the stopper 682, and the stopper 682 is positioned between the third dam DAM3 and the flatness-enhancing pattern 690. The flatness-enhancing pattern 690 may be positioned to be closer to the stopper 682 than the display area DA. For example, the flatness-enhancing pattern 690 may have a first distance from the display area DA and a second distance, which is smaller than the first distance, from the stopper 682.

The flatness-enhancing pattern 690 includes a plurality of concave patterns formed on a top surface of the inorganic insulating layer 674. The plurality of concave patterns may be formed by removing a part of the inorganic insulating layer 674. Alternatively, each concave pattern may have a depth being same as or similar to a thickness of the organic interlayer insulating layer 670. For example, each concave pattern may be spaced apart from each other along a first direction X and a second direction Y being perpendicular to the first direction X. A surface area of the inorganic insulating layer 674 in the non-display area NDA is increased by the plurality of concave patterns. Accordingly, a spreading speed of the solution for forming the second planarization layer 684 toward the stopper 682 can be increased by the flatness-enhancing pattern 690, and the protruding limitation of the second planarization layer 684 in the front area A (of FIG. 3) of the stopper 682 can be prevented, reduced, or minimized.

Each of the stopper 682 and the third dam DAM3 has a closed rectangular ring shape surrounding the display area DA, and the plurality of convex patterns of the flatness-enhancing pattern 690 are spaced apart from each other.

The inorganic insulating layer 674 may be surface-treated so that the spreading speed of the solution for forming the second planarization layer 684 may be further increased. For example, a plasma treatment using an oxygen gas may be performed onto the inorganic insulating layer 674. In this case, it is preferred not to perform the surface-treatment (e.g., the plasma-treatment) on the third dam DAM3.

Referring to FIGs. 6 and 10, in an aspect of the present disclosure, the non-display area NDA may include a first non-display area NDA1 disposed at the first direction X to the display area DA, a second non-display area NDA2 disposed at the second direction Y to the display area DA and a third non-display area NDA3 disposed between the first and second non-display areas NDA1 and NDA2. For example, the third non-display area NDA3 may correspond to a corner of the display area DA. The flatness-enhancing pattern 690 including the plurality of convex patterns in the first to third non-display areas NDA1, NDA2 and NDA3 has the same or substantially same shape, the same or substantially same size and the same or substantially same density.

Referring to FIGs. 7 and 10, in an aspect of the present disclosure, the non-display area NDA may include a first non-display area NDA1 disposed at the first direction X to the display area DA and a second non-display area NDA2 disposed at the second direction Y to the display area DA, and the flatness-enhancing pattern 690 includes a plurality of first flatness-enhancing patterns (e.g., a plurality of first concave patterns) disposed in the first non-display area NDA1 and a plurality of second flatness-enhancing patterns (e.g., a plurality of second concave patterns) disposed in the second non-display area NDA2. The plurality of first flatness-enhancing patterns have a first density (e.g., a special frequency), and the plurality of flatness-enhancing pattern have a second density being smaller than the first density.

The non-display area NDA may further include a third non-display area NDA3 between the first and second non-display areas NDA1 and NDA2, i.e., a corner of the display area DA. The flatness-enhancing pattern 690 may further include a plurality of third flatness-enhancing patterns (e.g., a plurality of third concave patterns) in the third non-display area NDA3. The third flatness-enhancing pattern may have a third density being smaller than the first density and greater than the second density.

Referring to FIGs. 8 and 10, in an aspect of the present disclosure, the non-display area NDA may include a first non-display area NDA1 disposed at the first direction X to the display area DA and a second non-display area NDA2 disposed at the second direction Y to the display area DA, and the flatness-enhancing pattern 690 includes a plurality of first flatness-enhancing patterns (e.g., a plurality of first concave patterns) disposed in the first non-display area NDA1 and a plurality of second flatness-enhancing patterns (e.g., a plurality of second concave patterns) disposed in the second non-display area NDA2. The first flatness-enhancing pattern has a major axis along the first direction X and a minor axis along the second direction Y, and the second flatness-enhancing pattern has a major axis along the second direction Y and a minor axis along the first direction X.

The non-display area NDA may further include a third non-display area NDA3 between the first and second non-display areas NDA1 and NDA2, i.e., a corner of the display area DA. The flatness-enhancing pattern 690 may further include a plurality of third flatness-enhancing patterns (e.g., a plurality of third concave patterns) in the third non-display area NDA3. The third flatness-enhancing pattern may have a major axis along a third direction toward the display area DA among the directions crossing the first and second directions X and Y and a minor axis along a fourth direction crossing the first direction X, the second direction Y and the third direction. The fourth direction may be perpendicular to the third direction.

In an aspect of the present disclosure, the non-display area NDA may include a first non-display area NDA1 disposed at the first direction X to the display area DA and a second non-display area NDA2 disposed at the second direction Y to the display area DA, and the flatness-enhancing pattern 690 includes a plurality of first flatness-enhancing patterns (e.g., a plurality of first concave patterns) disposed in the first non-display area NDA1 and a plurality of second flatness-enhancing patterns (e.g., a plurality of second concave patterns) disposed in the second non-display area NDA2. The first flatness-enhancing pattern has a first depth, and the second flatness-enhancing pattern has a second depth being smaller than the first depth.

The non-display area NDA may further include a third non-display area NDA3 between the first and second non-display areas NDA1 and NDA2, i.e., a corner of the display area DA. The flatness-enhancing pattern 690 may further include a plurality of third flatness-enhancing patterns (e.g., a plurality of third concave patterns) in the third non-display area NDA3. The third flatness-enhancing pattern may have a third depth being smaller than the first depth and greater than the second depth.

A second planarization layer 684 covering and planarizing the lenses 680 is disposed over the substrate 602. The second planarization layer 684 may be formed of an organic insulating material, e.g., acryl resin, epoxy resin, phenolic resin, polyamide resin or polyimide resin. The organic insulating material of the lens 680 has a first refractive index, and the organic insulating material of the second planarization layer 684 has a second refractive index being smaller than the first refractive index.

The second planarization layer 684 may be disposed in an area surrounded by the third dam DAM3 to cover the lenses 680, the flatness-enhancing pattern 690 and the stopper 682. Alternatively, the second planarization layer 684 may be disposed in an area surrounded by the stopper 682 to cover the lenses 680 and the flatness-enhancing pattern 690.

The trench structure B serves as a buffer for controlling a flow of a solution for forming the second planarization layer 684. The second planarization layer 684 in the trench structure B, i.e., a space between the organic insulating layer 662b of the encapsulation layer 662 and the first dam DAM1, may have a thickness being greater than the second planarization layer 684 in the display area DA.

The solution for forming the second planarization layer 684 is dropped on the display area DA and then spreads toward the non-display area NDA. The spreading speed of the solution for forming the second planarization layer 684 is increased due to the flatness-enhancing pattern 690 provided between the display area DA and the stopper 682 so that the flatness of the second planarization layer 684 can be improved.

In addition, the flow of the solution for forming the second planarization layer 684 is controlled by the trench structure B, which is provided by the organic insulating layer 662b of the encapsulation layer 662 and the first dam DAM1. Accordingly, the solution for forming the second planarization layer 684 is reduced or prevented from flowing over the third dam DAM3, and the flatness of the second planarization layer 684 can be further improved.

Moreover, the flatness-enhancing pattern 690 including a concave pattern includes a first flatness-enhancing pattern disposed in the first non-display area NDA1 at the first direction X from the display area DA, a second flatness-enhancing pattern disposed in the second non-display area NDA2 at the second direction Y from the display area DA and a third flatness-enhancing pattern disposed in the third non-display area NDA3 at a corner between the first and second non-display areas NDA1 and NDA2. The first flatness-enhancing pattern, the second flatness-enhancing pattern and the third flatness-enhancing pattern have a difference in at least one of a density, an arranging direction and a depth so that the flatness of the second planarization layer 684 in an entire surface of the organic light emitting display device 600 can be further improved.

It will be apparent to those skilled in the art that various modifications and variations can be made in the embodiments of the present disclosure without departing from the technical idea or scope of the present disclosure. Thus, it is intended that the modifications and variations cover this disclosure provided they come within the scope of the appended claims and their equivalents.

The present disclosure also includes the following numbered clauses:
Clause 1. A display device, comprising:
   a substrate;
   a display area and a non-display area outside the display area;
   a light emitting diode disposed in the display area and on the substrate;
   an insulating layer covering the light emitting diode and disposed in the display area and the non-display area;
   a plurality of lenses disposed in the display area and on the insulating layer;
   a stopper disposed in the non-display area and on the insulating layer;
   a plurality of a first flatness-enhancing patterns disposed between the display area and the stopper; and
   a planarization layer covering the plurality of lenses, the stopper and the plurality of first flatness-enhancing patterns,
   wherein the non-display area includes a first non-display area disposed in a first direction with respect to the display area and a second non-display area disposed in a second direction perpendicular to the first direction with respect to the display area, and
   wherein the plurality of first flatness-enhancing patterns are disposed in the first non-display area and include a convex pattern or a concave pattern.
Clause 2. The display device according to clause 1, wherein the plurality of first flatness-enhancing patterns are spaced apart from each other along the first direction and the second direction.
Clause 3. The display device according to any preceding clause, wherein each lens of the plurality of lenses has a major axis along the first direction and a minor axis along the second direction.
Clause 4. The display device according to any preceding clause, further comprising:
   a plurality of second flatness-enhancing patterns disposed in the second non-display area and between the display area and the stopper,
   wherein a density of the plurality of first flatness-enhancing patterns is greater than a density of the plurality of second flatness-enhancing patterns.
Clause 5. The display device according to any preceding clause, further comprising:
   a plurality of third flatness-enhancing patterns disposed in a corner between the first and second non-display areas,
   wherein a density of the plurality of third flatness-enhancing patterns is smaller than the density of the plurality of first flatness-enhancing patterns and greater than the density of the plurality of second flatness-enhancing patterns.
Clause 6. The display device according to any preceding clause, wherein each of the plurality of first flatness-enhancing patterns has a major axis along the first direction and a minor axis along the second direction.
Clause 7. The display device according to any preceding clause, further comprising:
   a plurality of second flatness-enhancing patterns disposed in the second non-display area and between the display area and the stopper,
   wherein each of the plurality of first flatness-enhancing patterns has a major axis along the second direction and a minor axis along the first direction.
Clause 8. The display device according to any preceding clause, further comprising:
   a plurality of third flatness-enhancing patterns disposed in a corner between the first and second non-display areas,
   wherein each of the plurality of third flatness-enhancing patterns has a major axis along a third direction crossing the first and second directions.
Clause 9. The display device according to any preceding clause, further comprising:
   a plurality of second flatness-enhancing patterns disposed in the second non-display area and between the display area and the stopper,
   wherein a height of the plurality of first flatness-enhancing patterns is greater than a height of the plurality of second flatness-enhancing patterns.
Clause 10. The display device according to any preceding clause, further comprising:
   a plurality of third flatness-enhancing patterns disposed in a corner between the first and second non-display areas,
   wherein a height of the plurality of third flatness-enhancing patterns is smaller than the height of the plurality of first flatness-enhancing patterns and greater than the height of the plurality of second flatness-enhancing patterns.
Clause 11. The display device according to any preceding clause, further comprising:
   a plurality of second flatness-enhancing patterns disposed in the second non-display area and between the display area and the stopper,
   wherein a depth of the plurality of first flatness-enhancing patterns is greater than a depth of the plurality of second flatness-enhancing patterns.
Clause 12. The display device according to any preceding clause, further comprising:
   a plurality of third flatness-enhancing patterns disposed in a corner between the first and second non-display areas,
   wherein a depth of the plurality of third flatness-enhancing patterns is smaller than the depth of the plurality of first flatness-enhancing patterns and greater than the depth of the plurality of second flatness-enhancing patterns.
Clause 13. The display device according to any preceding clause, further comprising:
   a first dam disposed outside the stopper,
   wherein the planarization layer extends to the first dam.
Clause 14. The display device according to any preceding clause, further comprising:
   a second dam disposed between the first dam and the stopper; and
   an encapsulation layer covering the second dam and disposed under the insulating layer,
   wherein the encapsulation layer includes a first inorganic insulating layer, an organic insulating layer and a second inorganic insulating layer,
   wherein each of the first and second inorganic insulating layer covers the second dam, and the organic insulating layer is spaced apart from the second dam, and
   wherein the planarization layer between the second dam and the encapsulation layer is thicker than the planarization layer in the display area.
Clause 15. The display device according to any preceding clause, wherein a density of the plurality of first flatness-enhancing patterns is greater than a density of the plurality of lenses.
Clause 16. The display device according to any preceding clause, wherein each of the plurality of first flatness-enhancing patterns is the convex pattern and has a first height, and
   wherein each of the plurality of lenses has a second height being greater than the first height.
Clause 17. The display device according to any preceding clause, wherein the stopper has a third height being greater than the first height and equal to or smaller than the second height.
Clause 18. The display device according to any preceding clause, wherein a first flatness-enhancing pattern of the plurality of first flatness-enhancing patterns has a first distance from the display area and a second distance from the stopper, and
   wherein the second distance is smaller than the first distance.
Clause 19. The display device according to any preceding clause, further comprising:
   a plurality of second flatness-enhancing patterns disposed in the second non-display area and between the display area and the stopper; and
   a plurality of third flatness-enhancing patterns disposed in a corner between the first and second non-display areas,
   wherein each of the plurality of first flatness-enhancing patterns, the plurality of second flatness-enhancing patterns and the plurality of third flatness-enhancing patterns is the convex pattern, and
   wherein the plurality of first flatness-enhancing patterns, the plurality of second flatness-enhancing patterns and the plurality of third flatness-enhancing patterns have a difference in at least one of a density, an arranging direction and a height.
Clause 20. The display device according to any preceding clause, further comprising:
   a plurality of second flatness-enhancing patterns disposed in the second non-display area and between the display area and the stopper; and
   a plurality of third flatness-enhancing patterns disposed in a corner between the first and second non-display areas,
   wherein each of the plurality of first flatness-enhancing patterns, the plurality of second flatness-enhancing patterns and the plurality of third flatness-enhancing patterns is the concave pattern, and wherein the plurality of first flatness-enhancing patterns, the plurality of second flatness-enhancing patterns and the plurality of third flatness-enhancing patterns have a difference in at least one of a density, an arranging direction and a depth.

## Claims

1. A display device, comprising:
a substrate;
a display area and a non-display area outside the display area;
a light emitting diode disposed in the display area and on the substrate;
an insulating layer covering the light emitting diode and disposed in the display area and the non-display area;
a plurality of lenses disposed in the display area and on the insulating layer;
a stopper disposed in the non-display area and on the insulating layer;
a plurality of a first flatness-enhancing patterns disposed between the display area and the stopper; and
a planarization layer covering the plurality of lenses, the stopper and the plurality of first flatness-enhancing patterns,
wherein the non-display area includes a first non-display area disposed in a first direction with respect to the display area and a second non-display area disposed in a second direction perpendicular to the first direction with respect to the display area, and
wherein the plurality of first flatness-enhancing patterns are disposed in the first non-display area and include a convex pattern or a concave pattern.

2. The display device according to claim 1, wherein the plurality of first flatness-enhancing patterns are spaced apart from each other along the first direction and the second direction.

3. The display device according to claim 1, wherein each lens of the plurality of lenses has a major axis along the first direction and a minor axis along the second direction.

4. The display device according to claim 3, further comprising:
a plurality of second flatness-enhancing patterns disposed in the second non-display area and between the display area and the stopper,
wherein a density of the plurality of first flatness-enhancing patterns is greater than a density of the plurality of second flatness-enhancing patterns; and
optionally further comprising:
a plurality of third flatness-enhancing patterns disposed in a corner between the first and second non-display areas,
wherein a density of the plurality of third flatness-enhancing patterns is smaller than the density of the plurality of first flatness-enhancing patterns and greater than the density of the plurality of second flatness-enhancing patterns.

5. The display device according to claim 3, wherein each of the plurality of first flatness-enhancing patterns has a major axis along the first direction and a minor axis along the second direction.

6. The display device according to claim 5, further comprising:
a plurality of second flatness-enhancing patterns disposed in the second non-display area and between the display area and the stopper,
wherein each of the plurality of first flatness-enhancing patterns has a major axis along the second direction and a minor axis along the first direction; and
optionally further comprising:
a plurality of third flatness-enhancing patterns disposed in a corner between the first and second non-display areas,
wherein each of the plurality of third flatness-enhancing patterns has a major axis along a third direction crossing the first and second directions.

7. The display device according to claim 3, further comprising:
a plurality of second flatness-enhancing patterns disposed in the second non-display area and between the display area and the stopper,
wherein a height of the plurality of first flatness-enhancing patterns is greater than a height of the plurality of second flatness-enhancing patterns; and
optionally further comprising:
a plurality of third flatness-enhancing patterns disposed in a corner between the first and second non-display areas,
wherein a height of the plurality of third flatness-enhancing patterns is smaller than the height of the plurality of first flatness-enhancing patterns and greater than the height of the plurality of second flatness-enhancing patterns.

8. The display device according to claim 3, further comprising:
a plurality of second flatness-enhancing patterns disposed in the second non-display area and between the display area and the stopper,
wherein a depth of the plurality of first flatness-enhancing patterns is greater than a depth of the plurality of second flatness-enhancing patterns.

9. The display device according to claim 8, further comprising:
a plurality of third flatness-enhancing patterns disposed in a corner between the first and second non-display areas,
wherein a depth of the plurality of third flatness-enhancing patterns is smaller than the depth of the plurality of first flatness-enhancing patterns and greater than the depth of the plurality of second flatness-enhancing patterns.

10. The display device according to claim 1, further comprising:
a first dam disposed outside the stopper,
wherein the planarization layer extends to the first dam; and
optionally further comprising:
a second dam disposed between the first dam and the stopper; and
an encapsulation layer covering the second dam and disposed under the insulating layer,
wherein the encapsulation layer includes a first inorganic insulating layer, an organic insulating layer and a second inorganic insulating layer,
wherein each of the first and second inorganic insulating layer covers the second dam, and the organic insulating layer is spaced apart from the second dam, and
wherein the planarization layer between the second dam and the encapsulation layer is thicker than the planarization layer in the display area.

11. The display device according to claim 1, wherein a density of the plurality of first flatness-enhancing patterns is greater than a density of the plurality of lenses.

12. The display device according to claim 8, wherein each of the plurality of first flatness-enhancing patterns is the convex pattern and has a first height, and
wherein each of the plurality of lenses has a second height being greater than the first height; and
optionally wherein the stopper has a third height being greater than the first height and equal to or smaller than the second height.

13. The display device according to claim 1, wherein a first flatness-enhancing pattern of the plurality of first flatness-enhancing patterns has a first distance from the display area and a second distance from the stopper, and
wherein the second distance is smaller than the first distance.

14. The display device according to claim 1, further comprising:
a plurality of second flatness-enhancing patterns disposed in the second non-display area and between the display area and the stopper; and
a plurality of third flatness-enhancing patterns disposed in a corner between the first and second non-display areas,
wherein each of the plurality of first flatness-enhancing patterns, the plurality of second flatness-enhancing patterns and the plurality of third flatness-enhancing patterns is the convex pattern, and
wherein the plurality of first flatness-enhancing patterns, the plurality of second flatness-enhancing patterns and the plurality of third flatness-enhancing patterns have a difference in at least one of a density, an arranging direction and a height.

15. The display device according to claim 1, further comprising:
a plurality of second flatness-enhancing patterns disposed in the second non-display area and between the display area and the stopper; and
a plurality of third flatness-enhancing patterns disposed in a corner between the first and second non-display areas,
wherein each of the plurality of first flatness-enhancing patterns, the plurality of second flatness-enhancing patterns and the plurality of third flatness-enhancing patterns is the concave pattern, and
wherein the plurality of first flatness-enhancing patterns, the plurality of second flatness-enhancing patterns and the plurality of third flatness-enhancing patterns have a difference in at least one of a density, an arranging direction and a depth.
